(19) **Europäisches Patentamt European Patent Office Office européen des brevets**

(11) **EP 4 597 542 A1**

(12) **EUROPEAN PATENT APPLICATION**
published in accordance with Art. 153(4) EPC

(43) Date of publication:
**06.08.2025 Bulletin 2025/32**

(21) Application number: **24866594.5**

(22) Date of filing: **07.11.2024**

(51) International Patent Classification (IPC):
**H01L** $^{(2006.01)}$

(52) Cooperative Patent Classification (CPC):
Y02E 10/50

(86) International application number:
**PCT/CN2024/130624**

(87) International publication number:
**WO 2025/130417 (26.06.2025 Gazette 2025/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **28.04.2024 CN 202410517763**

(71) Applicant: **LONGi Green Energy Technology Co., Ltd**
**Xi'an, Shaanxi 710100 (CN)**

(72) Inventors:
• **LI, Zhenguo**
  **Xi'an, Shaanxi 710100 (CN)**
• **TONG, Hongbo**
  **Xi'an, Shaanxi 710100 (CN)**
• **DENG, Shengjie**
  **Xi'an, Shaanxi 710100 (CN)**
• **LI, Jinyu**
  **Xi'an, Shaanxi 710100 (CN)**
• **YU, Long**
  **Xi'an, Shaanxi 710100 (CN)**
• **QIU, Jialiang**
  **Xi'an, Shaanxi 710100 (CN)**
• **FAN, Kai**
  **Xi'an, Shaanxi 710100 (CN)**

(74) Representative: **Grünecker Patent- und Rechtsanwälte**
**PartG mbB**
**Leopoldstraße 4**
**80802 München (DE)**

(54) **SOLAR CELL AND PHOTOVOLTAIC MODULE**

(57)    A solar cell includes a solar cell body, a plurality of fingers, and a plurality of first interconnection structures. At least a part of regions of different first interconnection structures distributed at intervals along a second direction are collinear with a same connection line of a plurality of connection lines. A quantity of connection lines located on the same target side is N1, a quantity of first interconnection structures intersecting with a target line segment located on the target side is N2, and

$$N2 < \frac{1}{2} N1$$

. The target line segment is a connection line segment between a midpoint of an edge that has a larger length in two edges of the target side extending along a first direction and being arranged opposite to each other and a vertex-angle endpoint corresponding to an edge that has a smaller length in the two edges.

FIG. 1

EP 4 597 542 A1

## Description

## CROSS-REFERENCE TO RELATED APPLICATIONS

The present application claims priority to Chinese Patent No. 202410517763.7, entitled "SOLAR CELL AND PHOTOVOLTAIC MODULE", and filed with the China National Intellectual Property Administration on April 28, 2024, which is incorporated herein by reference in its entirety.

## TECHNICAL FIELD

The present application relates to the technical field of photovoltaics, and in particular, to a solar cell and a photovoltaic module.

## BACKGROUND

Currently, as a new energy alternative solution, a solar cell is more widely used. A photovoltaic solar cell is an apparatus that converts light energy of the sun into electrical energy. Specifically, the solar cell generates a carrier based on a photovoltaic effect, and then extracts the carrier by using an electrode, to help effectively use the electrical energy.

However, in a solar cell in the related art, an interconnection structure is arranged at an improper position on a solar cell body. As a result, interconnection stress caused after adjacent solar cells are interconnected is large, and a splitting risk is greatly increased. Consequently, structural reliability of a photovoltaic module is reduced.

## SUMMARY

An objective of the present application is to provide a solar cell and a photovoltaic module, to reduce interconnection stress caused after adjacent solar cells are interconnected, so that a splitting risk of the solar cell is reduced, and structural reliability of the photovoltaic module is improved.

To achieve the foregoing objective, according to a first aspect, the present application provides a solar cell. The solar cell includes a solar cell body, a plurality of fingers, and a plurality of first interconnection structures. The solar cell body has a first side and a second side opposite to the first side. At least one of the first side and the second side is a target side. The plurality of fingers are arranged on the target side. Different fingers arranged on a same target side at intervals along a second direction extend along a first direction. The first direction is perpendicular to the second direction. The first interconnection structures are arranged in an array on the target side. Each of the plurality of first interconnection structures is electrically connected to at least one of the plurality of fingers. At least a part of regions of different first interconnection structures arranged at intervals along the second direction are collinear with a same connection line of a plurality of connection lines, and different connection lines of the plurality of connection lines are distributed at intervals along the first direction. A quantity of connection lines located on the same target side is N1, a quantity of first interconnection structures intersecting with a target line segment located on the target side is N2, and $N2 < \dfrac{1}{2}$ N1. The target line segment is a connection line segment between a midpoint of an edge that has a larger length in two edges of the target side extending along the first direction and being arranged opposite to each other and a vertex-angle endpoint corresponding to an edge that has a smaller length in the two edges. Alternatively, a quantity of connection lines intersecting with a vector line segment whose inclination angle is 45 degrees is N3, a quantity of first interconnection structures intersecting with the same vector line segment whose inclination angle is 45 degrees is N4, and N3 > N4.

When the foregoing technical solution is used, in the solar cell provided in the present application, the multiple first interconnection structures are arranged on the target side of the solar cell body, and the multiple first interconnection structures are arranged in an array on the target side. Each of the multiple first interconnection structures is electrically connected to the at least one of the multiple fingers. In addition, at least the part of the regions of the different first interconnection structures arranged at intervals along the second direction are collinear with the same connection line of the plurality of connection lines, and the different connection lines of the plurality of connection lines are distributed at intervals along the first direction. In this case, when adjacent solar cells are interconnected along an extension direction of the connection line by using an intra-string interconnection member such as a welding strip, the intra-string interconnection member in one-to-one correspondence with the connection line is electrically connected, at least by using the first interconnection structure, to a finger that is located on the target side and that has a polarity the same as that of the solar cell, so that a carrier collected by the finger is sequentially exported through the first interconnection structure and the intra-string interconnection member, to form a photocurrent. However, after the adjacent solar cells are interconnected, since materials and coefficients of thermal expansion of the first interconnection structure and the solar cell body are different, **interconnection** stress is generated after the interconnection. Based on this, the target line segment is in contact with at most a half of all the connection lines located on the same target side. **In** addition, when $N2 < \dfrac{1}{2} N1$, it can be ensured that no first interconnection structure that can be in electrical contact with each of the at least one connection line intersecting with the target line segment on the target side in arranged on the target line segment. Therefore, after the adjacent solar cells are interconnected along the extension direction of the connection line by using the intra-string interconnection member, none of the corresponding first interconnection structures in electrical contact with each of the at least one intra-string interconnection members generates interconnection stress on the target line segment, thereby reducing interconnection stress caused along an extension direction of the target line segment. **In** this case, a direction of a diagonal line of a surface of a semiconductor wafer for manufacturing the solar cell is approximately parallel to a cleavage surface, and the cleavage surface is a surface on which a mineralogical crystal is strictly cracked along a crystal direction under an external force, and a smooth surface can be obtained through cracking. Therefore, corresponding to a silicon wafer, a nearly square silicon wafer is formed after linear cutting is performed on a monocrystalline silicon crystal rod, the cleavage surface intersects with a surface of the silicon wafer, and is not parallel to an edge of the silicon wafer. It may be understood that there are countless cleavage surfaces that are parallel to each other in the crystal rod, and countless target line segments that are parallel to each other are formed between the cleavage surfaces and the surface of the silicon wafer. A diagonal line of the silicon wafer corresponding to a longest target line segment, and faces a largest stress challenge. However, a position of the target line segment remains unchanged before and after the silicon wafer is cut in half. Therefore, when the target line segment is the connection line segment between the midpoint of the edge (e.g., a non-chamfered edge) that has the larger length in the two edges of the target side extending along the first direction and being arranged opposite to each other and the vertex-angle endpoint corresponding to the edge (e.g., a chamfered edge) that has the smaller length in the two edges, the extension direction of the target line segment is approximately parallel to a direction of the cleavage surface of the solar cell body. **In** this case, reducing the interconnection stress caused along the extension direction of the target line segment is equivalent to reducing interconnection stress caused along the direction of the cleavage surface, to reduce a risk that splitting occurs after the solar cell suffers the external force due to the large interconnection stress, and improve structural reliability of a photovoltaic module formed based on the solar cell. **In** addition, when the quantity N3 of the connection lines corresponding to the vector line segment whose inclination angle is 45 degrees is greater than the quantity N4 of the first interconnection structures intersecting with the vector line segment, none of the first interconnection structures on the at least one connection line is arranged on the vector line segment whose inclination angle is 45 degrees. Therefore, after the adjacent solar cells are interconnected along the extension direction of the connection line by using the intra-string interconnection member, none of the corresponding first interconnection structures in electrical contact with each of the at least one intra-string interconnection members generates interconnection stress on the vector line segment whose inclination angle is 45 degrees, so that a length of an interconnection stress zone formed along an extension direction of the vector line segment whose inclination angle is 45 degrees is reduced. In addition, the cleavage surface of the solar cell body is approximately parallel to the vector line segment whose inclination angle is 45 degrees. Therefore, when the length of the interconnection stress zone formed along the extension direction of the vector line segment whose inclination angle is 45 degrees is reduced, a length of an interconnection stress zone formed along the direction of the cleavage surface is also facilitated to be reduced, to reduce a risk that splitting occurs after the solar cell suffers the external force due to the long interconnection stress zone, and improve the structural reliability of the photovoltaic module formed based on the solar cell.

In an embodiment, a thickness of the solar cell body is H1, a thickness of the first interconnection structure is H2, and a ratio of H2 to H1 is greater than or equal to 0.005 and less than or equal to 0.1.

When the foregoing technical solution is used, a case in which, because the ratio is small, the thickness of the first interconnection structure is also small, resulting in a failure in performing effective electrical interconnection with the intra-string interconnection member (reducing an interconnection pulling force), can be avoided, to ensure that the photovoltaic module obtained after the interconnection has high structural and electricity reliability. In addition, a case in which, because the ratio is small, the thickness of the first interconnection structure is also small, indirectly resulting in a large transmission loss of the carrier at the first interconnection structure, is also avoided, to ensure a high power of the solar cell. In addition, a case in which, because the ratio is large, the thickness of the first interconnection structure is also large, resulting in large interconnection stress between the first interconnection structure and the solar cell body after the interconnection, can also be avoided, to further reduce the risk that the splitting occurs when the solar cell suffers the external force after the interconnection, and improve the structural reliability of the photovoltaic module.

In an embodiment, a cross-sectional area of the solar cell body is S1, a cross-sectional area of the first interconnection structures is S2, and a ratio of S2 to S1 is greater than or equal to 0.0003 and less than or equal to 0.02. In this case, when the ratio is small, a large transmission resistance of the carrier at the first interconnection structure in response to a small cross-sectional area of the first interconnection structures can be avoided, to ensure a high power of the solar cell. In addition, when the ratio is large, a large light-shielding loss of the solar cell in response to a large cross-sectional area of the first interconnection structures can be avoided, to ensure high conversion efficiency of the solar cell.

In an embodiment, N2 is equal to 0. In this case, the quantity of the first interconnection structures intersecting with the target line segment is 0. The direction of the diagonal line of the surface of the semiconductor wafer for manufacturing the solar cell is approximately parallel to the cleavage surface. Therefore, in this case, a quantity of first interconnection structures arranged on the cleavage surface that is of the solar cell body and that is parallel to the extension direction of the target line segment is 0, so that a risk that splitting occurs on the cleavage surface after the solar cell suffers the external force can be reduced to the greatest extent, and the structural reliability of the photovoltaic module formed based on the solar cell is improved.

In an embodiment, a distance between a geometric center of the plurality of first interconnection structures intersecting with the target line segment or the vector line segment whose inclination angle is 45 degrees and a median line of the solar cell along the second direction is D3, and a distance between the geometric center of the plurality of first interconnection structures intersecting with the target line segment or the vector line segment whose inclination angle is 45 degrees and an edge of the solar cell along the second direction is D4. D3 corresponding to at least one of the first interconnection structures > D4. In this case, the distance between the geometric center of the plurality of first interconnection structures intersecting with the target line segment or the vector line segment whose inclination angle is 45 degrees and the edge of the solar cell along the second direction is smaller, to help avoid dense distribution, on the median line of the solar cell along the second direction, of the first interconnection structures intersecting with the target line segment or the vector line segment whose inclination angle is 45 degrees, reduce a risk that splitting occurs at a position at which the median line of the solar cell along the second direction intersects with the target line segment (or the vector line segment whose inclination angle is 45 degrees) after the intersection, and further improve the structural reliability of the photovoltaic module formed based on the solar cell. In addition, when the quantity of the first interconnection structures increases, uniformity of current collection performed by the finger and feasibility of the interconnection of the adjacent solar cells can be balanced, to help improve working performance of the photovoltaic module.

In an embodiment, the solar cell is a solar cell with no busbar. The target side includes a middle region and an edge region along the second direction. At least a part of the plurality of fingers located in the edge region are in direct contact with the first interconnection structure.

When the foregoing technical solution is used, when the solar cell is the solar cell with no busbar, a carrier collected by the corresponding finger may be directly transmitted, via the first interconnection structure in contact with the finger, to the intra-string interconnection member such as a welding strip, and exported. The carrier does not need to be sequentially transmitted to the first interconnection structure and the intra-string interconnection member through conduction by a busbar, so that a transmission loss of the carrier at the busbar can be eliminated, a light-shielding loss is also reduced, and working efficiency of the solar cell is improved.

In an embodiment, the solar cell is a back contact substrate structure, and the plurality of fingers include a plurality of first fingers and a plurality of second fingers having opposite polarities to the plurality of first fingers. The plurality of first fingers and the plurality of second fingers are alternately distributed at intervals along the second direction. At least a part of the plurality of first fingers in the edge region are in direct contact with respective first interconnection structures of the plurality of first interconnection structures, and at least a part of the plurality of second fingers in the edge region are in direct contact with respective first interconnection structures of the plurality of first interconnection structures.

In an embodiment, the solar cell further includes a plurality of second interconnection structures arranged on the target side. Each of the plurality of second interconnection structures is electrically connected to at least one of the plurality of fingers, and a size of the plurality of second interconnection structures is less than a size of the plurality of first interconnection structures. At least a part of regions of each of the plurality of second interconnection structures are located on a same straight line, and are collinear with the connection line. One part of the plurality of fingers located on the same target side are in contact with the plurality of first interconnection structures, and the other part of the plurality of fingers are in contact with the plurality of second interconnection structures. The part of the plurality of fingers in contact with the plurality of first interconnection structures are connection electrodes. A distance between two adjacent connection electrodes along the second direction is D1. At least one of the connection electrodes located in the edge region is in contact with the plurality of first interconnection structures, and different first interconnection structures in contact with a same connection electrode are distributed at intervals along the first direction. A distance between geometric centers of two adjacent first interconnection structures in contact with the same connection electrode is D2. D2 corresponding to at least one pair of the first interconnection structures is not equal to D1, and each pair of the first interconnection structures are two adjacent first interconnection structures in contact with the same connection electrode.

When the foregoing technical solution is used, one part of the plurality of fingers located on the same target side are in contact with the plurality of first interconnection structures having a larger size, to increase contact areas between the fingers and the intra-string interconnection member, thereby facilitating reducing a contact resistance between the intra-string interconnection member and the fingers, and facilitating improving connection strength between the intra-string interconnection member and the fingers. In addition, the other part of the plurality of fingers are in contact with the plurality of second interconnection structures having a smaller size, to help reduce a metal composite loss on a side of the target side, and help improve the working efficiency of the solar cell. In addition, in the solar cell, first interconnection structures that are in contact with different connection electrode and that are on a same layer are aligned along the first direction, to reduce difficulty in connection of an automatic interconnection device, such as a series welding machine, interconnecting the adjacent solar cells. In this case, when D2 corresponding to the at least one pair of the first interconnection structures is not equal to D1, an inclination angle of a connection line between a first interconnection structure at a layer arranged on a connection electrode and a first interconnection structure at an adjacent layer arranged on an adjacent connection electrode is not equal to 45 degrees, so that an inclination angle of an interconnection stress zone corresponding to the pair of first interconnection structures is not equal to 45 degrees, to help reduce the length of the interconnection stress zone formed along the extension direction of the vector line segment whose inclination angle is 45 degrees, and also help reduce the length of the interconnection stress zone formed along the direction of the cleavage surface. Therefore, the risk that splitting occurs after the solar cell suffers the external force due to the long interconnection stress zone is reduced, and the structural reliability of the photovoltaic module formed based on the solar cell is improved.

In an embodiment, a quantity of the plurality of second interconnection structures intersecting with the target line segment or the vector line segment whose inclination angle is 45 degrees is N7. $N7 > \frac{1}{3} N1$; and/or N7 < N1.

When the foregoing technical solution is used, when the quantity N7 of second interconnection structures intersecting with the target line segment or the vector line segment whose inclination angle is 45 degrees is greater than $\frac{1}{3} N1$, the second interconnection structures can be enabled to have a large distribution density on the target side, to ensure sufficient interconnection strength. In addition, for a high-temperature process of manufacturing the solar cell, a sintering temperature of an electrode is usually above 600 °C. During sintering and cooling, due to a difference between coefficients of thermal expansion, large stress exists between the first interconnection structure having the larger size and the solar cell body. When the stress is excessively large, splitting of the solar cell easily occurs. Although the size of the plurality of second interconnection structures is smaller, for the solar cell with no busbar, the distribution density of the second interconnection structures on the target side may be large. Consequently, hidden crack formed inside the solar cell with no busbar deteriorates, causing a splitting risk of the solar cell. Based on this, when N7 is less than N1, it can be ensured that none of the second interconnection structures on the at least one connection line that can intersect with the target line segment (or the vector line segment whose inclination angle is 45 degrees) on the target side is arranged on the target line segment (or the vector line segment whose inclination angle is 45 degrees). Therefore, after the adjacent solar cells are interconnected along the extension direction of the connection line by using the intra-string interconnection member, none of the corresponding second interconnection structures intersecting with the at least one intra-string interconnection member generates sintering stress on the target line segment, to reduce sintering stress formed along the extension direction of the target line segment, prevent an increase in the splitting risk of the solar cell caused by the large distribution density of the second interconnection structures on the target side, and ensure that the solar cell has a high yield rate.

In an embodiment, when the part of the plurality of fingers in contact with the plurality of first interconnection structures are the connection electrodes, a ratio of D1 corresponding to the at least one pair of the first interconnection structures to D2 is greater than or equal to 6 and less than or equal to 12.

When the foregoing technical solution is used, when the ratio of D1 corresponding to the at least one pair of the first interconnection structures to D2 is within the foregoing range, it is beneficial to avoid a case in which an extension direction of an interconnection stress zone corresponding to the at least one pair of the first interconnection structures approaches the extension direction of the cleavage surface because the ratio is small, thereby ensuring that the length of the interconnection stress zone formed along the direction of the cleavage surface can be reduced. In addition, it is also beneficial to avoid a case in which, because the ratio is large, a distance between the two adjacent first interconnection structures intersecting with the same connection electrode is also large, resulting in a large transmission loss of a carrier at the connection electrode. This helps improve the working efficiency of the solar cell.

In an embodiment, the solar cell further includes a plurality of busbars arranged on the target side. Different busbars located on the same target side extend along the second direction and are distributed at intervals along the first direction. The plurality of busbars are electrically connected to the plurality of fingers having a same polarity as the plurality of busbars, respectively, and are in electrical contact with at least one of the plurality of first interconnection structures. Different busbars are in one-to-one correspondence with different connection lines.

When the foregoing technical solution is used, in an actual application process, a wire width of the finger is usually small, to reduce a light-shielding area of the finger. However, the finger is consequently prone to be cracked. However, existence of the busbar can enable carriers collected by the finger on two side of a cracking part to be respectively transmitted to busbars connected to the finger, and exported, to improve a current collection capability and reducing a power loss.

In an embodiment, the plurality of busbars are connection electrodes. A distance between two adjacent connection electrodes along the first direction is D1. At least one of the connection electrodes is in contact with the plurality of first interconnection structures, and different first interconnection structures in contact with a same connection electrode are distributed at intervals along the second direction. A distance between geometric centers of two adjacent first interconnection structures in contact with the same connection electrode is D2. D2 corresponding to at least one pair of the first interconnection structures is not equal to D1, and each pair of the first interconnection structures are two adjacent first interconnection structures in contact with the same connection electrode. For beneficial effects in this case, refer to the foregoing descriptions, and details are not described herein again.

In an embodiment, the plurality of fingers include a plurality of first fingers and a plurality of second fingers having opposite polarities to the plurality of first fingers. The plurality of first fingers and the plurality of second fingers are alternately distributed at intervals along the second direction. In addition, the busbars include a plurality of first busbars and a plurality of second busbars having opposite polarities to the plurality of first busbars. The plurality of first busbars and the plurality of second busbars are alternately distributed at intervals along the first direction. The plurality of busbars and the plurality of fingers that have opposite polarities are mutually isolated.

In an embodiment, when the busbars are the connection electrodes, a ratio of D2 corresponding to the at least one pair of the first interconnection structures to D1 is greater than or equal to 1 and less than or equal to 1.7.

When the foregoing technical solution is used, it may be understood that, when a length of the connection electrode is fixed, a larger ratio of D2 corresponding to the at least one pair of the first interconnection structures to D1 indicates a larger distance between the two adjacent first interconnection structures intersecting with the same connection electrode. On the contrary, a smaller ratio of D2 corresponding to the at least one pair of the first interconnection structures to D1 indicates a smaller distance between the two adjacent first interconnection structures intersecting with the same connection electrode. However, when the ratio is closer to 1, an inclination angle of a connection line between the pair of first interconnection structures is closer to 45 degrees, that is, closer to the extension direction of the cleavage surface. In the foregoing case, when the ratio of D2 corresponding to the at least one pair of the first interconnection structures to D1 is within the foregoing range, it is beneficial to avoid a case in which an extension direction of an interconnection stress zone corresponding to the at least one pair of the first interconnection structures approaches the extension direction of the cleavage surface because the ratio is small, thereby ensuring that the length of the interconnection stress zone formed along the direction of the cleavage surface can be reduced. In addition, it is also beneficial to avoid a case in which, because the ratio is large, a distance between the two adjacent first interconnection structures intersecting with the same connection electrode is also large, resulting in a large transmission loss of a carrier at the connection electrode. This helps improve the working efficiency of the solar cell.

According to a second aspect, the present application provides another solar cell. The solar cell includes a solar cell body, a plurality of fingers, and a plurality of first interconnection structures. The solar cell body has a first side and a second side opposite to the first side. At least one of the first side and the second side is a target side. The plurality of fingers are arranged on the target side. Different fingers arranged on a same target side at intervals along a second direction extend along a first direction. The first direction is perpendicular to the second direction. The plurality of first interconnection structures are arranged in an array on the target side. Each of the plurality of first interconnection structures is electrically connected to the at least one of the plurality of fingers. At least a part of regions of different first interconnection structures arranged at intervals along the second direction are collinear with a same connection line of a plurality of connection lines, and different connection lines of the plurality of connection lines are distributed at intervals along the first direction. A quantity of connection lines located on the same target side is N1, a quantity of first interconnection structures intersecting with a target line segment located on the target side is N2, and N1 > N2. The target line segment is a diagonal line of the target side, and intersects with each of the connection lines.

When the foregoing technical solution is used, the target line segment is the diagonal line of the target side, and intersects with each of the connection lines. In addition, when N2 < N1, it can be ensured that no first interconnection structure that can be in electrical contact with each of the at least one connection line intersecting with the target line segment on the target side in arranged on the target line segment. Therefore, after the adjacent solar cells are interconnected along the extension direction of the connection line by using the intra-string interconnection member, none of the corresponding first interconnection structures in electrical contact with each of the at least one intra-string interconnection members generates interconnection stress on the target line segment, thereby reducing interconnection stress caused along an extension direction of the target line segment. **In** this case, a direction of a diagonal line of a surface of a semiconductor wafer for manufacturing the solar cell is approximately parallel to a cleavage surface, and the cleavage surface is a surface on which a mineralogical crystal is strictly cracked along a crystal direction under an external force, and a smooth surface can be obtained through cracking. Therefore, corresponding to a silicon wafer, a nearly square silicon wafer is formed after linear cutting is performed on a monocrystalline silicon crystal rod, the cleavage surface intersects with a surface of the silicon wafer, and is not parallel to an edge of the silicon wafer. It may be understood that there are countless cleavage surfaces that are parallel to each other in the crystal rod, and countless target line segments that are parallel to each other are formed between the cleavage surfaces and the surface of the silicon wafer. A diagonal line of the silicon wafer corresponding to a longest target line segment, and faces a largest stress challenge. Therefore, when the target line segment is the diagonal line of the target side, the extension direction of the target line segment is approximately parallel to a direction of the cleavage surface of the solar cell body. **In** this case, reducing the interconnection stress caused along the extension direction of the target line segment is equivalent to reducing interconnection stress caused along the direction of the cleavage surface, to reduce a risk that splitting occurs after the solar cell suffers the external force due to the large interconnection stress, and improve structural reliability of a photovoltaic module formed based on the solar cell.

In an embodiment, the solar cell further includes a plurality of busbars arranged on the target side. Different busbars located on the same target side extend along the second direction and are distributed at intervals along the first direction. The plurality of busbars are electrically connected to the plurality of fingers having a same polarity as the plurality of busbars, respectively, and are in electrical contact with at least one of the plurality of first interconnection structures. The different busbars are in one-to-one correspondence with the different connection lines. In this case, in an actual application process, a wire width of the finger is usually small, to reduce a light-shielding area of the finger. However, the finger is consequently prone to be cracked. However, existence of the busbar can enable carriers collected by the finger on two side of a cracking part to be respectively transmitted to busbars connected to the finger, and exported, to improve a current collection capability and reducing a power loss.

In an embodiment, when the solar cell includes at least two sliced cell units distributed at intervals along the second direction, a cutting channel is provided between two adjacent sliced cell units. Fingers having opposite polarities in two adjacent sliced cell units are symmetrically arranged relative to the cutting channel, and/or first interconnection structures having opposite polarities in the two adjacent sliced cell units are symmetrically arranged relative to the cutting channel, and/or busbars having opposite polarities in the two adjacent sliced cell units are symmetrically arranged relative to the cutting channel. In this case, in the two adjacent sliced cell units, at least one pair of the fingers, first interconnection structures, and busbars having opposite polarities are symmetrically arranged relative to the cutting channel, to facilitate interconnection between the pair, avoid dislocation, improve an interconnection yield rate, and reduce interconnection difficulty.

In an embodiment, the solar cell includes M sliced cell units distributed at intervals along the second direction, and M is a positive integer greater than or equal to 1. Geometric centers of two first interconnection structures located at an edge along the second direction in a same sliced cell unit are symmetrically arranged relative to a median line of the same sliced cell unit along the second direction.

When the foregoing technical solution is used, the geometric centers of the two first interconnection structures located at the edge along the second direction in the same sliced cell unit are symmetrically arranged relative to the central axis of the sliced cell unit along the second direction, to help enable an automatic interconnection device, such as a series welding machine, to interconnect different sliced cell units at a same starting position, thereby preventing dislocation that is between an intra-string interconnection member, such as a welding strip, and a first interconnection structure arranged on the solar cell body and that is caused by different starting positions corresponding to the different sliced cell units, where the dislocation further causes a case in which a carrier on a connection electrode corresponding to the first interconnection structure not electrically connected to the intra-string interconnection member cannot be exported via the intra-string interconnection member, and a power loss occurs, or causes a case in which the corresponding first interconnection structure becomes a load, resulting in reduction of working efficiency of the solar cell. Therefore, it is ensured that a photovoltaic module formed based on the solar cell provided in the present application has good working performance.

In an embodiment, the solar cell is a back contact substrate structure, and the plurality of fingers include a plurality of first fingers and a plurality of second fingers having opposite polarities to the plurality of first fingers. The plurality of first fingers and the plurality of second fingers are alternately distributed at intervals along the second direction. At least a part of the plurality of first fingers in the edge region are in direct contact with respective first interconnection structures of the plurality of first interconnection structures, and at least a part of the plurality of second fingers in the edge region are in direct contact with respective first interconnection structures of the plurality of first interconnection structures.

In an embodiment, when two busbars located on an outer side along the first direction have opposite polarities, in the plurality of first interconnection structures intersecting with the target line segment, at least two first interconnection structures have a same distance to a median line of the target side along the second direction and have a same polarity. In this case, distribution uniformity of different first interconnection structures that are located on the same target side and have a same polarity is improved, and difficulty in interconnecting the adjacent solar cells by using an automatic interconnection device such as a series welding machine is reduced.

In an embodiment, when the solar cell includes two sliced cell units distributed at intervals along the second direction, N2 corresponding to the two sliced cell units are equal. Two busbars located on an outer side along the first direction in a same sliced cell unit have opposite polarities. Two busbars that are arranged opposite to each other on an outer side along the first direction and belong to different sliced cell units have opposite polarities. In this case, symmetry between different first interconnection structures that are located on the same target side and have opposite polarities is improved, and difficulty in interconnecting the adjacent solar cells by using an automatic interconnection device such as a series welding machine is reduced.

In an embodiment, when the solar cell includes two sliced cell units distributed at intervals along the second direction, N2 corresponding to the two sliced cell units are not equal. Two busbars located on an outer side along the first direction in a same sliced cell unit have a same polarity. Two busbars that are arranged opposite to each other on an outer side along the first direction and belong to different sliced cell units have opposite polarities. In this case, another possible implementation is provided for the solar cell provided in the present application, to improve applicability of the solar cell provided in the present application in different application scenarios.

In an embodiment, the solar cell is a solar cell with no busbar. The solar cell further includes a plurality of second interconnection structures arranged on the target side. Each of the plurality of second interconnection structures is electrically connected to at least one of the plurality of fingers, and a size of the plurality of second interconnection structures is less than a size of the plurality of first interconnection structures. At least a part of regions of each of the plurality of second interconnection structures are located on a same straight line, and are collinear with the connection line. One part of the plurality of fingers located on the same target side are in contact with the plurality of first interconnection structures, and the other part of the plurality of fingers are in contact with the plurality of second interconnection structures. A quantity of the plurality of second interconnection structures intersecting with the target line segment is N8.

$$N8 > \frac{1}{2} N1$$

, and/or N8 < 1.5 N1. For an application principle of beneficial effects in this case, refer to the foregoing application principle of $N7 > \frac{1}{3} N1$ and N7 < N1, and details are not described herein again.

According to a third aspect, the present application provides a photovoltaic module. The photovoltaic module includes the solar cell provided in the first aspect and the implementations of the first aspect, or includes the solar cell provided in the second aspect and the implementations of the second aspect.

For beneficial effects of the third aspect and various implementations of the third aspect in the present application, refer to analysis of the beneficial effects of the first aspect and the implementations of the first aspect, or refer to analysis of the beneficial effects of the second aspect and the implementations of the second aspect, and details are not described herein again.

According to a fourth aspect, the present application provides another photovoltaic module. The photovoltaic module includes a plurality of solar cells and a plurality of intra-string interconnection members each connecting two adjacent solar cells in series. Each of the plurality of solar cells includes a solar cell body, a plurality of fingers, and a plurality of first interconnection structures. The solar cell body has a first side and a second side opposite to the first side. At least one of the first side and the second side is a target side. The plurality of fingers are arranged on the target side. Different fingers arranged on a same target side at intervals along a second direction extend along a first direction. The first direction is perpendicular to the second direction. Each of the first interconnection structures is electrically connected to the at least one of the plurality of fingers. Each of the intra-string interconnection members is in electrical contact with a corresponding first interconnection structure. A quantity of first interconnection structures intersecting with a target line segment located on the target side is N2, and the target line segment is a connection line segment between a midpoint of an edge that has a larger length in two edges of the target side extending along the first direction and being arranged opposite to each other and a vertex-angle endpoint corresponding to an edge that has a smaller length in the two edges. A quantity of intra-string interconnection members located on the same target side is N5. A quantity of first interconnection structures intersecting with the same vector line segment whose inclination angle is 45 degrees is N4. A quantity of intra-string interconnection members intersecting with the same vector line segment whose inclination angle is 45 degrees is N6.

$$N2 < \frac{1}{2} N5$$

, or N6 > N4.

In an embodiment, N2 corresponding to at least two solar cells in a same photovoltaic module are equal.

For beneficial effects of the fourth aspect and various implementations of the fourth aspect in the present application, refer to analysis of the beneficial effects of the first aspect and the implementations of the first aspect, and details are not described herein again.

**BRIEF DESCRIPTION OF THE DRAWINGS**

The accompanying drawings described herein are used to provide further understanding of the present application and constitute a part of the present application. Example embodiments of the present application and descriptions of the embodiments are used to explain the present application, and do not constitute an improper limitation on the present application. In the accompanying drawings:

FIG. 1 is a first schematic structural diagram of a solar cell according to an embodiment of the present application;

FIG. 2 is a second schematic structural diagram of a solar cell according to an embodiment of the present application;

FIG. 3 is a third schematic structural diagram of a solar cell according to an embodiment of the present application;

FIG. 4 is a fourth schematic structural diagram of a solar cell according to an embodiment of the present application;

FIG. 5 is a schematic diagram of rooting a semiconductor substrate for manufacturing a solar cell body according to an embodiment of the present application;

FIG. 6 is a schematic diagram of distribution of a diagonal line on a target side according to an embodiment of the present application;

FIG. 7 is a schematic diagram of a distribution relationship between a part of connection electrodes and a part of interconnection structures according to an embodiment of the present application;

FIG. 8 is a fifth schematic structural diagram of a solar cell according to an embodiment of the present application;

FIG. 9 is a sixth schematic structural diagram of a solar cell according to an embodiment of the present application;

FIG. 10 is a seventh schematic structural diagram of a solar cell according to an embodiment of the present application;

FIG. 11 is an eighth schematic structural diagram of a solar cell according to an embodiment of the present application;

FIG. 12 is a schematic diagram of another distribution relationship between a part of connection electrodes and a part of interconnection structures according to an embodiment of the present application;

FIG. 13 is a ninth schematic structural diagram of a solar cell according to an embodiment of the present application; and

FIG. 14 is a tenth schematic structural diagram of a solar cell according to an embodiment of the present application.

Reference numerals: 11: solar cell body, 12: finger, 13: first interconnection structure, 14: second interconnection structure, 15: connection electrode, and 16: busbar.

## DETAILED DESCRIPTION

Embodiments of the present application are described below with reference to the accompanying drawings. However, it should be understood that descriptions are merely examples, and are not intended to limit the scope of the present application. In addition, descriptions of well-known structures and technologies are omitted in the following descriptions, to avoid unnecessarily obscuring the concepts of the present application.

Schematic diagrams of various structure in the embodiments of the present application are shown in the accompanying drawings. The figures are not drawn to scale. For an objective of clear expression, some details are enlarged, and some details may be omitted. Shapes of various regions and layers and relative sizes and position relationships between the regions and the layers shown in the figures are merely examples. In practice, there may be a deviation due to a manufacturing tolerance or a technical limitation, and a person skilled in the art may additionally design regions/layers having different shapes, sizes and relative positions according to actual needs.

In contexts of the present application, when a layer/element is referred to as being "above" another layer/element, the layer/element may be directly above another layer/element, or a middle layer/element may exist between the layer/element and another layer/element. In addition, if a layer/element is "above" another layer/element in an orientation, the layer/element may be "below" another layer/element when the orientation is reversed. To make to-be-resolved technical problems, technical solutions, and beneficial effects of the present application clearer and more comprehensible, the present application is further described in detail below with reference to the accompanying drawings and the embodiments. It should be understood that the specific embodiments described herein are merely used for explaining the present application but are not intended to limit the present application.

In addition, the terms "first" and "second" are merely intended for a purpose of description, and shall not be understood as indicating or implying relative significance or implicitly indicating a quantity of indicated technical features. Therefore, features defining "first" and "second" can explicitly or implicitly include one or more of the features. In the descriptions of the present disclosure, unless clearly and specifically defined otherwise, "a plurality of" means two or more than two. Unless clearly and specifically defined otherwise, "several" means one or more.

In the descriptions of the present disclosure, it should be noted that, unless otherwise clearly specified and defined, terms such as "mounting", "interconnection", and "connection" shall be understood in a broad sense, for example, may be a fixing connection, a detachable connection, an integral connection, a mechanical connection, an electrical connection, a direct connection, an indirect connection by using an intermediate medium, communication between interiors of two components, or interaction between two components. A person of ordinary skill in the art may understand specific meanings of the terms in the present disclosure according to specific situations.

Currently, as a new energy alternative solution, a solar cell is more widely used. A photovoltaic solar cell is an apparatus that converts light energy of the sun into electrical energy. Specifically, the solar cell generates a carrier based on a photovoltaic effect, and then extracts the carrier by using an electrode, to help effectively use the electrical energy.

Specifically, an existing solar cell usually includes a solar cell body, a plurality of fingers, and a plurality of interconnection structures. The fingers are arranged on a first side and/or a second side of the solar cell. Different fingers arranged on a same surface at intervals along a second direction extend along a first direction. The first direction is different from the second direction. The interconnection structures are arranged on a surface that is of the solar cell body and that has the finger, and the interconnection structure is a conductive structure configured to implement an electrical connection between the solar cell and an intra-string interconnection member. Each of the interconnection structures is in contact with at least one of the fingers, to interconnect adjacent solar cells by using the interconnection structure and the intra-string interconnection member such as a welding strip. Different interconnection structures located on the same plane are arranged in an array. At least a part of regions of different interconnection structures arranged at intervals along the second direction are collinear with a same connection line of a plurality of connection lines, and different connection lines of the plurality of connection lines are distributed at intervals along the first direction. A specific meaning of the connection line may be determined based on a type of the solar cell. Specifically, when the solar cell is a solar cell with no busbar, the connection line coincides with an orthographic projection of the intra-string interconnection member on the solar cell body. Alternatively, the connection line is a virtual line formed along an interconnection direction by using interconnection structures having a same polarity. When the solar cell is a solar cell with a busbar, the connection line coincides with an orthographic projection of a busbar on the solar cell body. When the solar cell is used in a photovoltaic module, the connection line coincides with an orthographic projection of the intra-string interconnection member on the solar cell body. For the entire solar cell, a quantity of connection lines is a quantity of connection lines in a single sliced cell unit on the same surface. When the solar cell is a back contact substrate structure, the quantity of connection lines is a sum of quantities of connection lines corresponding to a positive interconnection structure and a negative interconnection structure on a back surface of the solar cell.

However, in the foregoing existing solar cell, the interconnection structure is arranged at an improper distribution position on the solar cell body. Specifically, using the entire solar cell as an example, in the existing solar cell, the quantity of connection lines is less than or equal to a quantity of interconnection structures intersecting with a diagonal line. In addition, the diagonal line is a longest line segment on the surface of the solar cell body. In this case, after the intra-string interconnection member such as a welding strip is electrically connected to the interconnection structure along an extension direction of the connection line, to interconnect adjacent solar cells, on one surface of the solar cell body on which the interconnection structure is formed, since materials and coefficients of thermal expansion of the interconnection structure and the solar cell body are different, stress is caused between the interconnection structure and the solar cell body after the interconnection structure and the solar cell body are interconnected. Generally, a coefficient of thermal expansion of the solar cell body is smaller, and a coefficient of thermal expansion of the interconnection structure is larger. A stress difference may be caused between the interconnection structure and the solar cell body. A main material of the solar cell body is generally a silicon material, which is brittle. If excessively large stress is borne on the surface of the solar cell body, splitting may be caused. Generally, a ratio of the coefficient of thermal expansion of the solar cell body to the coefficient of thermal expansion of the interconnection structure is greater than 10. Using an example in which the material of the solar cell body is a silicon material, an electrode is a silver electrode, and the intra-string interconnection member is a copper welding strip, a coefficient of thermal expansion of the solar cell body is $2.6 \times 10^{-6}$/°C, and a coefficient of thermal expansion of the silver electrode is $1.9 \times 10^{-5}$/°C. A difference between the two coefficients of thermal expansion is large. A coefficient of thermal expansion of the copper welding strip is $1.7 \times 10^{-5}$/°C, and an interconnection and encapsulation temperature is generally about 150 °C or even higher. A difference between the coefficient of thermal expansion of the copper welding strip and the coefficient of thermal expansion of the solar cell body is also large, and stress concentrates at a position of the interconnection structure. Based on this, when the quantity of connection lines is less than or equal to the quantity of interconnection structures intersecting with the diagonal line, at least one interconnection structure intersects with the diagonal line on each connection line, and a stress zone extending along a direction of the diagonal line and having a large length is formed after the interconnection. Consequently, interconnection stress along the direction of the diagonal line is excessively large. However, the direction of the diagonal line is approximately parallel to a cleavage surface of the solar cell body. When the interconnection stress along the direction of the diagonal line is excessively large, a large increase in a splitting risk is easily caused, and structural reliability of the photovoltaic module is reduced.

To resolve the foregoing technical problem, according to a first aspect, an embodiment of the present application provides a solar cell. Specifically, the solar cell provided in this embodiment of the present application may be any solar cell that can convert light energy of the sun into electrical energy.

In terms of disposing positions of a positive electrode and a negative electrode, the solar cell provided in this embodiment of the present application may be a two-surface contact substrate structure, that is, one of the positive electrode and the negative electrode of the solar cell is arranged on a front surface of the solar cell, and the other is arranged on a back surface. Alternatively, the solar cell provided in this embodiment of the present application may be a back contact substrate structure, that is, both the positive electrode and the negative electrode of the solar cell are arranged on a back surface of the solar cell.

In terms of specific electrode structures of the positive electrode and the negative electrode, the solar cell provided in this embodiment of the present application may be a "solar cell with a busbar". In this case, the solar cell not only includes fingers, but also includes busbars, and different busbars are in one-to-one correspondence with different connection lines. Alternatively, the solar cell provided in this embodiment of the present application may be a "solar cell with no busbar". In this case, the solar cell with no busbar does not include the busbar in the solar cell with the busbar. Specifically, an electrode structure of the solar cell with no busbar may include only fingers, or may include fingers and a busbar segment that has an auxiliary bus function (where the busbar segment may be electrically connected to a first interconnection structure located at an edge along a second direction, and extends toward an edge of the solar cell body along the second direction). A specific shape of the busbar segment is not limited, and may be, for example, a straight line, a curved line, or a harpoon structure.

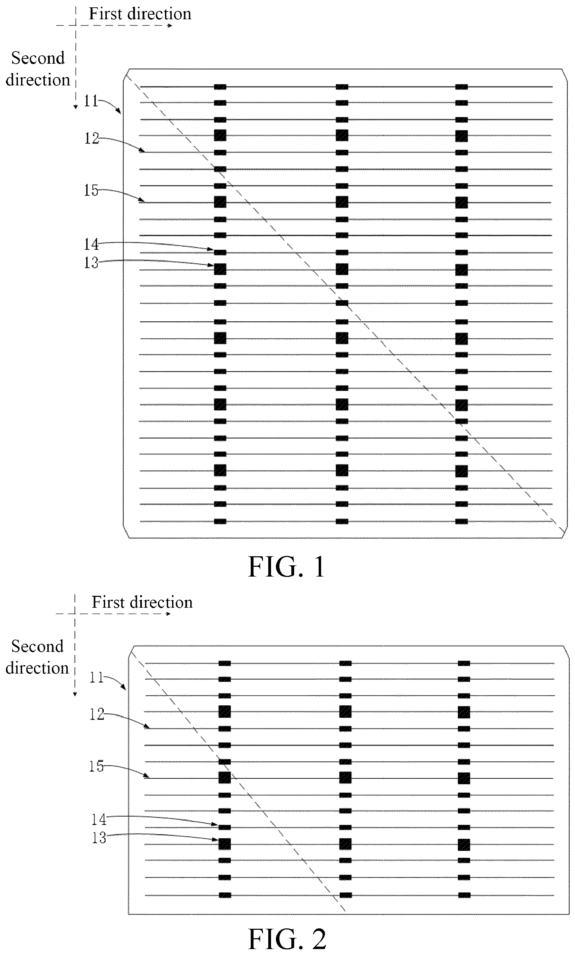

Specifically, as shown in FIG. 2 and FIG. 4, and FIG. 5 and FIG. 6, the solar cell provided in this embodiment of the present application includes a solar cell body 11, a plurality of fingers 12, and a plurality of first interconnection structures 13. The solar cell body 11 has a first side and a second side opposite to the first side. At least one of the first side and the second side is a target side. The plurality of fingers 12 are arranged on the target side. Different fingers 12 arranged on a same target side at intervals along a second direction extend along a first direction. The first direction is perpendicular to the second direction. The plurality of first interconnection structures 13 are arranged in an array on the target side. Each of the plurality of first interconnection structures 13 is electrically connected to the at least one of the plurality of fingers 12. At least a part of regions of different first interconnection structures 13 arranged at intervals along the second direction are collinear with a same connection line of a plurality of connection lines, and different connection lines of the plurality of connection lines are distributed at intervals along the first direction. A quantity of connection lines located on the same target side is N1, a quantity of first interconnection structures 13 intersecting with a target line segment located on the target side is N2, and $N2 < \frac{1}{2} N1$. The target line segment is a connection line segment between a midpoint of an edge that has a larger length in two edges of the target side extending along the first direction and being arranged opposite to each other and a vertex-angle endpoint corresponding to an edge that has a smaller length in the two edges. Alternatively, a quantity of connection lines intersecting with a vector line segment whose inclination angle is 45 degrees is N3, a quantity of first interconnection structures 13 intersecting with the same vector line segment whose inclination angle is 45 degrees is N4, and N3 > N4.

Specifically, the quantity N1 of connection lines is a positive integer greater than or equal to 1. The quantity N2 of first interconnection structures intersecting with the target line segment located on the target side is an integer greater than or equal to 0. In addition, it may be understood that, on the target side of the solar cell, there are countless vector line segments whose inclination angles are 45 degrees, and at least one vector line segment whose inclination angle is 45 degrees satisfies N3 > N4.

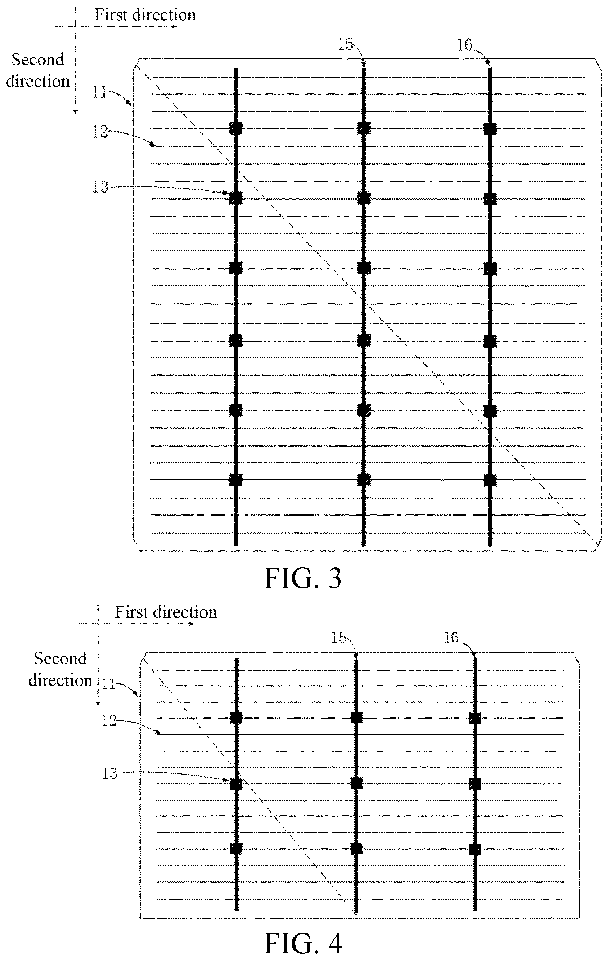

When the foregoing technical solution is used, as shown in FIG. 2 and FIG. 4, in the solar cell provided in this embodiment of the present application, the multiple first interconnection structures 13 are arranged on the target side of the solar cell body 11, and the multiple first interconnection structures 13 are arranged in an array on the target side. Each of the multiple first interconnection structures 13 is electrically connected to the at least one of the multiple fingers 12. In addition, at least the part of the regions of the different first interconnection structures 13 arranged at intervals along the second direction are collinear with the same connection line of the plurality of connection lines, and the different connection lines of the plurality of connection lines are distributed at intervals along the first direction. In this case, when adjacent solar cells are interconnected along an extension direction of the connection line by using an intra-string interconnection member such as a welding strip, the intra-string interconnection member in one-to-one correspondence with the connection line is electrically connected, at least by using the first interconnection structure 13, to a finger 12 that is located on the target side and that has a polarity the same as that of the solar cell, so that a carrier collected by the finger 12 is sequentially exported through the first interconnection structure 13 and the intra-string interconnection member, to form a photocurrent. However, after the adjacent solar cells are interconnected, since materials and coefficients of thermal **expansion** of the first interconnection structure 13 and the solar cell body 11 are different, interconnection stress is generated after the interconnection. Based on this, the target line segment is in contact with at most a half of the connection lines located on the same target side. In addition, when $N2 < \frac{1}{2}\,N1$, it can be ensured that no first interconnection structure 13 that can be in electrical contact with each of the at least one connection line intersecting with the target line segment on the target side in arranged on the target line segment. Therefore, after the adjacent solar cells are interconnected along the extension direction of the connection line by using the intra-string interconnection member, none of the corresponding first interconnection structures 13 in electrical contact with each of the at least one intra-string interconnection members generates interconnection stress on the target line segment, thereby reducing interconnection stress caused along an extension direction of the target line segment. In this case, a direction of a diagonal line of a surface of a semiconductor wafer for manufacturing the solar cell is approximately parallel to a cleavage surface, and the cleavage surface is a surface on which a mineralogical crystal is strictly cracked along a crystal direction under an external force, and a smooth surface can be obtained through cracking. Therefore, corresponding to a silicon wafer, a nearly square silicon wafer is formed after linear cutting is performed on a monocrystalline silicon crystal rod, the cleavage surface intersects with a surface of the silicon wafer, and is not parallel to an edge of the silicon wafer. It may be understood that there are countless cleavage surfaces that are parallel to each other in the crystal rod, and countless target line segments that are parallel to each other are formed between the cleavage surfaces and the surface of the silicon wafer. A diagonal line of the silicon wafer corresponding to a longest target line segment, and faces a largest stress challenge. However, a position of the target line segment remains unchanged before and after the silicon wafer is cut in half. Therefore, when the target line segment is the connection line segment between the midpoint of the edge (e.g., a non-chamfered edge) that has the larger length in the two edges of the target side extending along the first direction and being arranged opposite to each other and the vertex-angle endpoint corresponding to the edge (e.g., a chamfered edge) that has the smaller length in the two edges, the extension direction of the target line segment is approximately parallel to a direction of the cleavage surface of the solar cell body 11. In this case, reducing the interconnection stress caused along the extension direction of the target line segment is equivalent to reducing interconnection stress caused along the direction of the cleavage surface, to reduce a risk that splitting occurs after the solar cell suffers the external force due to the large interconnection stress, and improve structural reliability of a photovoltaic module formed based on the solar cell. In addition, when the quantity N3 of the connection lines intersecting with the vector line segment whose inclination angle is 45 degrees is greater than the quantity N4 of the first interconnection structures 13 intersecting with the vector line segment, none of the first interconnection structures 13 on the at least one connection line is arranged on the vector line segment whose inclination angle is 45 degrees. Therefore, after the adjacent solar cells are interconnected along the extension direction of the connection line by using the intra-string interconnection member, none of the corresponding first interconnection structures 13 in electrical contact with each of the at least one intra-string interconnection members generates interconnection stress on the vector line segment whose inclination angle is 45 degrees, so that a length of an interconnection stress zone formed along an extension direction of the vector line segment whose inclination angle is 45 degrees is reduced. In addition, the cleavage surface of the solar cell body 11 is approximately parallel to the vector line segment whose inclination angle is 45 degrees. Therefore, when the length of the interconnection stress zone formed along the extension direction of the vector line segment whose inclination angle is 45 degrees is reduced, a length of an interconnection stress zone formed along the direction of the cleavage surface is also facilitated to be reduced, to reduce a risk that splitting occurs after the solar cell suffers the external force due to the long interconnection stress zone, and improve the structural reliability of the photovoltaic module formed based on the solar cell.

It should be noted that the solar cell provided in the first aspect of the embodiments of the present application is a half of the solar cell. In addition, the direction of the diagonal line (that is, a diagonal line on the target side of the solar cell body of the entire solar cell) of the surface of the semiconductor wafer for manufacturing the solar cell, the direction of the vector line segment whose inclination angle is 45 degrees, and the direction of the target line segment in the half of the solar cell that are mentioned above are all approximately parallel to the cleavage surface. Therefore, when the diagonal line on the target side of the solar cell body of the entire solar cell, the direction of the vector line segment whose inclination angle is 45 degrees, and the direction of the target line segment in the half of the solar cell in this specification are replaced with an extension direction of the cleavage surface, a correspondence is also satisfied.

In addition, in an actual application process, the quantity N1 of the connection lines located on the target side and the quantity N2 of the first interconnection structures intersecting with the target line segment on the target side may be determined based on a distance between two adjacent connection lines along the second direction, a distance between two adjacent finger in electrical contact with the first interconnection structure, and a distribution situation of the first interconnection structures on the connection line, provided that the quantities can be applied to the solar cell provided in this embodiment of the present application.

For example, as shown in FIG. 4, N2 may be equal to 0. In this case, the quantity of the first interconnection structures 13 intersecting with the target line segment is 0. The direction of the diagonal line of the surface of the semiconductor wafer for manufacturing the solar cell is approximately parallel to the cleavage surface, and after the semiconductor wafer is cut in half, a position of the connection line segment between the midpoint of the edge that has a larger length in the two edges of the target side extending along the first direction and being arranged opposite to each other and the vertex-angle endpoint corresponding to the edge that has a smaller length in the two edges (that is, the target line segment) is a partial position of the diagonal line on the surface of the entire original semiconductor wafer, it can be learned that the target line segment is approximately parallel to the cleavage surface. Therefore, in this case, a quantity of first interconnection structures 13 arranged on the cleavage surface that is of the solar cell body 11 and that is parallel to the extension direction of the target line segment is 0, so that a risk that splitting occurs on the cleavage surface after the solar cell suffers the external force can be reduced to the greatest extent, and the structural reliability of the photovoltaic module formed based on the solar cell is improved. It should be noted that, the case in which N2 is equal to 0 is applicable to all of the solar cell with no busbar, the solar cell with a busbar, the back contact substrate structure, and the two-surface contact substrate structure.

In addition, the quantity N3 of the connection lines intersecting with the vector line segment whose inclination angle is 45 degrees and the quantity N4 of the first interconnection structures intersecting with the same vector line segment whose inclination angle is 45 degrees may also be determined based on the distance between the two adjacent connection lines along the second direction, the distance between the two adjacent finger in electrical contact with the first interconnection structure, and the distribution situation of the first interconnection structures on the connection line, provided that the quantities can be applied to the solar cell provided in this embodiment of the present application.

For the first interconnection structure, from an aspect of materials, a material of the first interconnection structure may include any one of electrically conductive materials such as silver, copper, aluminum, or tungsten.

In addition, as described above, the materials and the coefficients of thermal expansion of the solar cell body and the first interconnection structure are different. Therefore, after the interconnection, interconnection stress may be generated at a junction between the solar cell body and the first interconnection structure. When a size of the plurality of first interconnection structures is different, a magnitude of the interconnection stress generated at the junction between the solar cell body and the first interconnection structure after the interconnection may also be different. Specifically, when other factors are the same, within a particular range, after the adjacent solar cells are interconnected, the magnitude of the interconnection stress at the junction between the first interconnection structure and the solar cell body is directly proportional to a thickness of the first interconnection structure. In addition, within a particular range, the thickness of the first interconnection structure is inversely proportional to a transmission loss of the first interconnection structure. In the foregoing case, the size of the plurality of first interconnection structures may be determined at least based on requirements on the transmission loss of the first interconnection structure and the interconnection stress in an actual application scenario. This is not specifically limited herein.

For example, a thickness of the solar cell body is H1, and the thickness of the first interconnection structure is H2. Based on this, a ratio of H2 to H1 may be greater than or equal to 0.005 and less than or equal to 0.1. For example, the ratio of the thickness H2 of the interconnection structure to the thickness H1 of the solar cell body may be 0.005, 0.01, 0.02, 0.04, 0.06, 0.08, or 0.1. In this case, when the ratio of the thickness H2 of the first interconnection structure to the thickness H1 of the solar cell body is within the foregoing range, a case in which, because the ratio is small, the thickness of the first interconnection structure is also small, resulting in a failure in performing effective electrical interconnection with the intra-string interconnection member (reducing an interconnection pulling force), can be avoided, to ensure that the photovoltaic module obtained after the interconnection has high structural and electricity reliability. In addition, a case in which, because the ratio is small, the thickness of the first interconnection structure is also small, indirectly resulting in a large transmission loss of the carrier at the first interconnection structure, is also avoided, to ensure a high power of the solar cell. In addition, a case in which, because the ratio is large, the thickness of the first interconnection structure is also large, resulting in large interconnection stress between the first interconnection structure and the solar cell body after the interconnection, can also be avoided, to further reduce the risk that the splitting occurs when the solar cell suffers the external force after the interconnection, and improve the structural reliability of the photovoltaic module. It should be noted that, the case in which the ratio of H2 to H1 may be greater than or equal to 0.005 and less than or equal to 0.1 is applicable to all of the solar cell with no busbar, the solar cell with a busbar, the back contact substrate structure, and the two-surface contact substrate structure.

For example, a cross-sectional area of the solar cell body is defined as S1, and a cross-sectional area of the first interconnection structures is defined as S2. Based on this, a ratio of S2 to S1 may be greater than or equal to 0.0003 and less than or equal to 0.02. For example, a ratio of the cross-sectional area S2 of the interconnection structure to the cross-sectional area S1 of the solar cell body may be 0.0003, 0.0008, 0.001, 0.003, 0.005, 0.008, 0.01, or 0.02. When the ratio is small, a large transmission resistance of the carrier at the first interconnection structure in response to a small cross-sectional area of the first interconnection structures can be avoided. The ratio of S2 to S1 is within the foregoing range to ensure a high power of the solar cell. In addition, when the ratio is large, a large light-shielding loss of the solar cell in response to a large cross-sectional area of the first interconnection structures can be avoided. The ratio of S2 to S1 is within the foregoing range to ensure high conversion efficiency of the solar cell. It should be noted that, the case in which the ratio of S2 to S1 is greater than or equal to 0.0003 and less than or equal to 0.02 is applicable to all of the solar cell with no busbar, the solar cell with a busbar, the back contact substrate structure, and the two-surface contact substrate structure.

In addition, when the first interconnection structure satisfies both the ratio of H2 to H1 being greater than or equal to 0.005 and less than or equal to 0.1 and the ratio of S2 to S1 being greater than or equal to 0.0003 and less than or equal to 0.02, a balance among an interconnection pull force, a resistance loss, interconnection stress, and a light-shielding loss may be considered, to ensure that the solar cell has high conversion efficiency and that the photovoltaic module including the solar cell provided in this embodiment of the present application has high structural reliability and electrical performance.

The distribution situation of the first interconnection structures on the target side may be determined based on a distribution situation, a disposing quantity, and the like of the fingers and/or the busbars on the target side, provided that the distribution situation can be applied to the solar cell provided in this embodiment of the present application.

For example, as shown in FIG. 2 and FIG. 4, a distance between a geometric center of the plurality of first interconnection structures 13 intersecting with the target line segment and a median line of the solar cell along the second direction is defined as D3 (not shown in the figure). The median line along the second direction in the present application is a median line extending along the first direction and located at a middle position of the second direction. In addition, a distance between the geometric center of the plurality of first interconnection structures 13 intersecting with the target line segment and an edge of the solar cell along the second direction is defined as D4 (not shown in the figure). Based on this, D3 corresponding to at least one of the first interconnection structures 13 > D4. In this case, the distance between the geometric center of the plurality of first interconnection structures 13 intersecting with the target line segment and the edge of the solar cell along the second direction is smaller, to help avoid dense distribution, on the median line of the solar cell along the second direction, of the first interconnection structures 13 intersecting with the target line segment, reduce a risk that splitting occurs at a position at which the median line of the solar cell along the second direction intersects with the target line segment after the intersection, and further improve the structural reliability of the photovoltaic module formed based on the solar cell. In addition, when the quantity of the first interconnection structures 13 increases, uniformity of current collection performed by the finger 12 and feasibility of the interconnection of the adjacent solar cells can be balanced, to help improve working performance of the photovoltaic module. It should be noted that, the case in which D3 corresponding to the at least one of the first interconnection structures 13 > D4 is applicable to all of the solar cell with no busbar, the solar cell with a busbar, the back contact substrate structure, and the two-surface contact substrate structure.

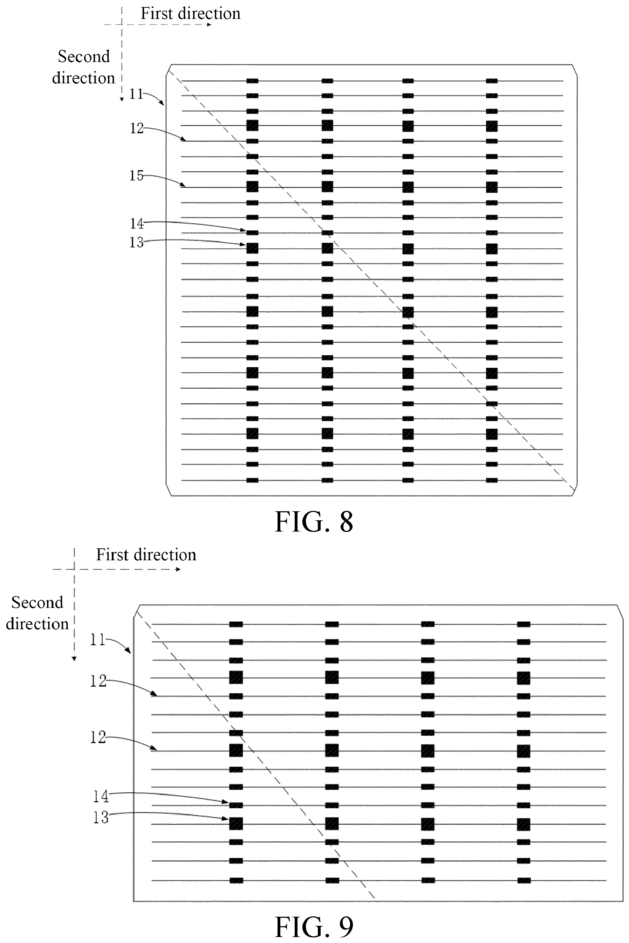

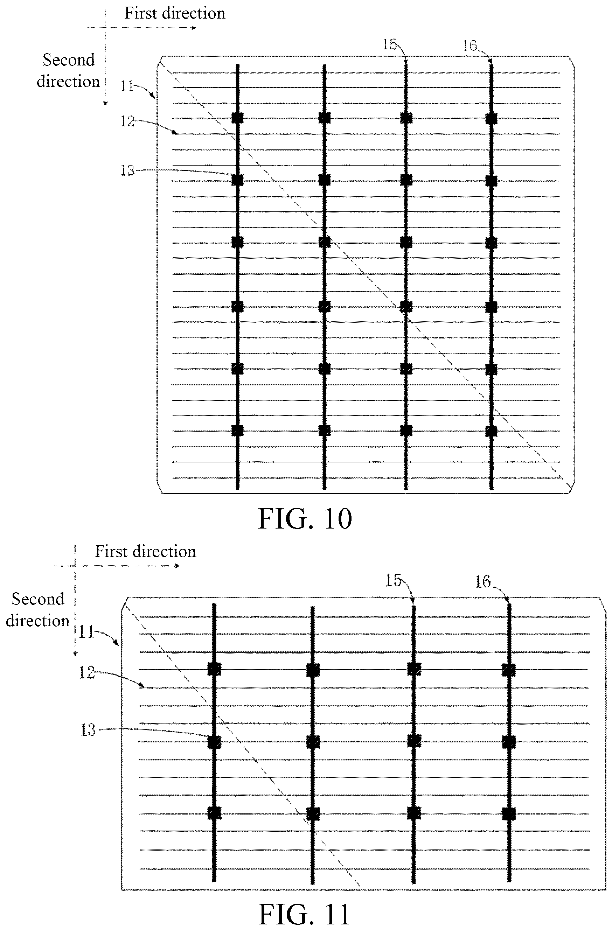

Certainly, as shown in FIG. 9 and FIG. 11, the distance D3 between the geometric center of the plurality of first interconnection structures 13 intersecting with the target line segment and the median line of the solar cell along the second direction may alternatively be less than or equal to the distance D4 between the geometric center of the plurality of first interconnection structures 13 intersecting with the target line segment and the edge of the solar cell along the second direction. Specific values of D3 and D4 may be determined based on distribution situations of the first interconnection structures 13 and the fingers 12 on the target side, and are not specifically limited herein.

In addition, a structure and a material of the solar cell body are not specifically limited in this embodiment of the present application, and may be determined based on a type of the solar cell and an actual application scenario, provided that the structure and the material can be applied to the solar cell provided in this embodiment of the present application.

For example, when the solar cell provided in this embodiment of the present application is of the two-surface contact substrate structure, the solar cell body may include at least a semiconductor substrate, a first doping semiconductor layer, and a second doping semiconductor layer. One of the first doping semiconductor layer and the second doping semiconductor layer is formed on a front surface corresponding to the semiconductor substrate, and the other is formed on a back surface corresponding to the semiconductor substrate. A conduction type of the first doping semiconductor layer is different from a conduction type of the second doping semiconductor layer.

The semiconductor substrate may be a substrate of any one of semiconductor materials such as a silicon substrate, a silicon-germanium substrate, a germanium substrate, or a gallium-arsenide substrate. A conduction type of the semiconductor substrate may be an N-type, a **P-**type, or an intrinsic type.

For the first doping semiconductor layer and the second doping semiconductor layer, materials of the first doping semiconductor layer and/or the second doping semiconductor layer may include any one of semiconductor material such as silicon, silicon germanium, or germanium. **In** terms of an arrangement form of substances, crystal phases of the first doping semiconductor layer and/or the second doping semiconductor layer may be non-crystal, microcrystal, nano-crystal, monocrystal, polycrystal, or the like. **In** terms of a conduction type, the conduction type of the first doping semiconductor layer may be N-type. **In** this case, the conduction type of the second doping semiconductor layer is P-type. Alternatively, the conduction type of the first doping semiconductor layer is P-type. **In** this case, the conduction type of the second doping semiconductor layer is N-type. Thicknesses of the first doping semiconductor layer and the second doping semiconductor layer may be set based on an actual requirement, and are not specifically limited herein. For example, the thickness of the first doping semiconductor layer or the second doping semiconductor layer may be greater than or equal to 100 nm and less than or equal to 500 nm.

For example, when the solar cell is the back contact substrate structure, the solar cell body may include at least a semiconductor substrate, a first doping semiconductor layer, and a second doping semiconductor layer. Conduction types of the first doping semiconductor layer and the second doping semiconductor layer are opposite, and the first doping semiconductor layer and the second doping semiconductor layer are both arranged on a back surface corresponding to the semiconductor substrate. At least a part of regions of the first doping semiconductor layer and at least a part of regions of the second doping semiconductor layer are spaced away. For information such as materials and thicknesses of the semiconductor substrate, the first doping semiconductor layer, and the second doping semiconductor layer, refer to the foregoing descriptions, and details are not described herein again.

The solar cell body has the first side and the second side opposite to the first side. The first side of the solar cell body may correspond to a front surface of the solar cell. **In** this case, the second side of the solar cell body may correspond to a back surface of the solar cell. **In** this case, the connection line is arranged on the target side of the solar cell body. Therefore, whether the target side is specifically the first side or the second side of the solar cell body, or whether both the first side and the second side are the target sides may be determined based on a type of the solar cell and an actual application scenario.

When the solar cell is of the two-surface contact substrate structure, the target side of the solar cell body may be only the first side of the solar cell body, or may be only the second side of the solar cell body, or may be both the first side and the second side of the solar cell body. When the solar cell is the back contact substrate structure, the target side of the solar cell body is one of the first side and the second side of the solar cell body that corresponds to the back surface of the solar cell.

**In** addition, it should be noted that, when a vertex angle of the target side is a sharp corner, the target line segment may be a connection line segment between a midpoint of any one of two edges arranged opposite to each other and extending along the first direction of the target side and a vertex-angle endpoint corresponding to the other edge. When the vertex angle of the target side is a chamfer in a manner such as rounded transition, the target line segment may be the connection line segment between the midpoint of the edge (e.g., a non-chamfered edge) that has the larger length in the two edges of the target side extending along the first direction and being arranged opposite to each other and the vertex-angle endpoint (where the vertex-angle endpoint is an endpoint of an extended line of the chamfer) corresponding to the edge (e.g., a chamfered edge) that has the smaller length in the two edges.

**In** addition, a specific structure and distribution of the electrode structures formed on the target side of the solar cell may be determined based on a type of the solar cell.

For example, as shown in FIG. 2, the target side includes a middle region and an edge region along the second direction. At least a part of the plurality of fingers 12 located in the edge region are in electrical contact with respective first interconnection structures 13 of the plurality of first interconnection structures 13. **In** this case, when the solar cell is the solar cell with no busbar, at least the part of the fingers 12 in the middle region is in contact with the second interconnection structure. A carrier collected by the corresponding finger 12 may be directly transmitted, via the first interconnection structure 13 in contact with the finger, to the intra-string interconnection member such as a welding strip, and exported. The carrier does not need to be transmitted to the first interconnection structure 13 and the intra-string interconnection member via a busbar, so that a transmission loss of the carrier at the busbar can be eliminated, a light-shielding loss is also reduced, and working efficiency of the solar cell is improved. When the solar cell is the solar cell with the busbar, at least the part of the fingers 12 in the middle region are in contact with the first interconnection structure 13. At least a part of the plurality of fingers 12 located in the edge region and the middle region are in contact with the first interconnection structure 13, so that interconnection strength can be improved. For example, a size of the plurality of first interconnection structures 13 located in the middle region is smaller than a size of the plurality of first interconnection structures 13 located in the edge region.

Specifically, that the size of the plurality of first interconnection structures in the edge region is greater than the size of the plurality of first interconnection structures in the middle region may mean that only a length of the first interconnection structure in the edge region is greater than a length of the first interconnection structure in the middle region along the first direction, or may mean that only a width of the first interconnection structure in the edge region is greater than a width of the first interconnection structure in the middle region along the second direction, or may mean that a length and a width of the first interconnection structure in the edge region are respectively greater than a length and a width of the first interconnection structure in the middle region.

On the target side, a region between two first interconnection structures located at the edge along the second direction (that is, one first interconnection structure located at the edge is arranged at each of two ends along the second direction) and the edge of the solar cell body is defined as the edge region of the target side, and a remaining region is defined as the middle region of the target side. In addition, in the foregoing case, when the solar cell is of the two-surface contact substrate structure, different fingers (which are all fingers included in the positive electrode or the negative electrode) located on the same target side have a same polarity. In this case, if the solar cell is the solar cell with no busbar, a quantity of all the connection lines includes a sum of quantities of connection lines intersecting with the first interconnection structures with the same polarity, that is, includes a quantity of connection lines formed by the first interconnection structures in contact with the fingers. In addition, the quantity of the first interconnection structures intersecting with the target line segment located on the target side also includes a quantity of first interconnection structures that are in contact with the fingers with the same polarity and that intersect with the target line segment. If the solar cell is the solar cell with the busbar, the quantity of all the connection lines includes a sum of quantities of busbar with a same polarity. In addition, the quantity of the first interconnection structures intersecting with the target line segment located on the target side also includes a quantity of first interconnection structures that are in contact with the busbars with the same polarity and that intersect with the target line segment.

When the solar cell is the back contact substrate structure, all the fingers located on the same target side include a plurality of first fingers and a plurality of second fingers having opposite polarities. The plurality of first fingers and the plurality of second fingers are alternately distributed at intervals along the second direction, to avoid electricity leakage. At least a part of the plurality of first fingers in the edge region are in contact with respective first interconnection structures of the plurality of first interconnection structures, and at least a part of the plurality of second fingers in the edge region are in electrical contact with respective first interconnection structures of the plurality of first interconnection structures. Specifically, the first finger may be a finger included in the positive electrode. In this case, the second finger is a finger included in the negative electrode. Alternatively, the first finger may be a finger included in the negative electrode. In this case, the second finger is a finger included in the positive electrode. In the foregoing case, when the solar cell is the solar cell with no busbar, the quantity of all the connection lines includes a sum of quantities of connection lines intersecting with first interconnection structures with two polarities, that is, includes a sum of a quantity of first connection lines formed by the first interconnection structures in contact with the first fingers and a quantity of second connection lines formed by the first interconnection structures in contact with the second fingers. In addition, the quantity of the first interconnection structures intersecting with the target line segment located on the target side also includes a sum of first interconnection structures that are of two polarities and that intersect with the target line segment located on the same target side, that is, includes a sum of a quantity of first interconnection structures in contact with the first fingers and intersecting with the target line segment, and a quantity of first interconnection structures in contact with the second fingers and intersecting with the target line segment. When the solar cell is the solar cell with the busbar, the quantity of all the connection lines includes a sum of quantities of busbars with two polarities. In addition, the quantity of the first interconnection structures intersecting with the target line segment located on the target side also includes a quantity of first interconnection structures that are in direct contact with the busbars with the two polarities and that intersect with the target line segment.

In addition, the solar cell provided in this embodiment of the present application may include only the first interconnection structures. Sizes of different first interconnection structures may be the same or may be different. For example, as shown in FIG. 3 and FIG. 4, the sizes of the different first interconnection structures 13 may be the same when the solar cell is the solar cell with the busbar. For another example, when the solar cell is the solar cell with the busbar, the sizes of the different first interconnection structures may alternatively be different, and the first interconnection structures having the different sizes have a small difference in sizes (where for example, along the second direction, a ratio of a size of a first interconnection structure having a larger size to a size of a first interconnection structure having a smaller size is greater than 1 and less than 2). In an embodiment, along the second direction, the target side includes the middle region and the edge region. The first interconnection structure having the larger size may be arranged in the edge region, and the first interconnection structure having the smaller size may be arranged in the middle region.

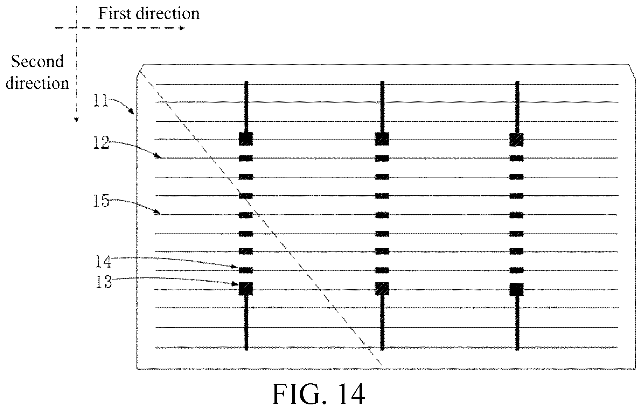

Alternatively, as shown in FIG. 2, FIG. 13, and FIG. 14, when the solar cell is the solar cell with no busbar, the solar cell may alternatively include a second interconnection structure 14 arranged on the target side. Each of the plurality of second interconnection structures 14 is electrically connected to at least one of the plurality of fingers 12, and a size of the plurality of second interconnection structures 14 is less than a size of the plurality of first interconnection structures 13. At least a part of regions of each of the plurality of second interconnection structures 14 are located on a same straight line, and are collinear with the connection line. In addition, one part of the plurality of fingers 12 located on the same target side are in contact with the plurality of first interconnection structures 13, and the other part of the plurality of fingers 12 are in contact with the plurality of second interconnection structures 14, so that carriers collected by the fingers 12 located on the same target side are respectively exported via the first interconnection structures 13 and the second interconnection structures 14. In this case, one part of the plurality of fingers 12 located on the same target side are in contact with the plurality of first interconnection structures 13 having a larger size, to increase contact areas between the fingers 12 and the intra-string interconnection member, thereby facilitating reducing a contact resistance between the intra-string interconnection member and the fingers 12, and facilitating improving connection strength between the intra-string interconnection member and the fingers 12. In addition, the other part of the plurality of fingers 12 are in contact with the plurality of second interconnection structures 14 having a smaller size, to help reduce a metal composite loss on a side of the target side, and help improve the working efficiency of the solar cell. For example, a finger 12 in the edge region is in contact with the first interconnection structure 13 having the larger size, and a finger 12 in the middle region is in contact with the first interconnection structure 13 having the smaller size. The second interconnection structure 14 may be a bold segment of the finger 12 or a design assisting in electrical connection. A size difference between the first interconnection structure 13 and the second interconnection structure 14 is large for the solar cell with no busbar.

Specifically, that the size of the plurality of first interconnection structures is greater than the size of the plurality of second interconnection structures may mean that only a length of the first interconnection structure is greater than a length of the second interconnection structure along the first direction, or may mean that only a width of the first interconnection structure is greater than a width of the second interconnection structure along the second direction, or may mean that a length and a width of the first interconnection structure are respectively greater than a length and a width of the second interconnection structure.

It should be noted that, for a high-temperature process of manufacturing the solar cell, a sintering temperature of an electrode is usually above 600 °C. During sintering and cooling, due to a difference between coefficients of thermal expansion, large stress exists between each of the first interconnection structure having the larger size and the second interconnection structure having the smaller size and the solar cell body. When the stress is excessively large, splitting of the solar cell easily occurs. Although the size of the plurality of second interconnection structures is smaller, for the solar cell with no busbar, the distribution density of the second interconnection structures on the target side may be large. Consequently, hidden crack formed inside the solar cell with no busbar deteriorates, causing a splitting risk of the solar cell. Therefore, specific sizes of the first interconnection structure and the second interconnection structure, and a distribution situation of the second interconnection structures on the target side may be determined based on a requirement on a yield rate of the solar cell in an actual application scenario. This is not specifically limited herein.

For example, when the solar cell is the solar cell with no busbar, a quantity of the plurality of second interconnection structures intersecting with the target line segment or the vector line segment whose inclination angle is 45 degrees is defined as N7. $N7 > \frac{1}{3} N1$; and/or N7 < N1. For example, N7 may be equal to 0.35 N1, 0.4 N1, 0.5 N1, 0.6 N1, 0.7 N1, 0.8 N1, or 0.9 N1. In this case, when the quantity N7 of second interconnection structures intersecting with the target line segment or the vector line segment whose inclination angle is 45 degrees is greater than $\frac{1}{3} N1$, the second interconnection structures can be enabled to have a large distribution density on the target side, to ensure sufficient interconnection strength. In addition, for a high-temperature process of manufacturing the solar cell, a sintering temperature of an electrode is usually above 600 °C. During sintering and cooling, due to a difference between coefficients of thermal expansion, large stress exists between each of the first interconnection structure having the larger size and the second interconnection structure having the smaller size and the solar cell body. When the stress is excessively large, splitting of the solar cell easily occurs. Although the size of the plurality of second interconnection structures is smaller, for the solar cell with no busbar, the distribution density of the second interconnection structures on the target side may be large. Consequently, hidden crack formed inside the solar cell with no busbar deteriorates, causing a splitting risk of the solar cell. Based on this, when N7 is less than N1, it can be ensured that none of the second interconnection structures on the at least one connection line that can intersect with the target line segment (or the vector line segment whose inclination angle is 45 degrees) on the target side is arranged on the target line segment (or the vector line segment whose inclination angle is 45 degrees). Therefore, after the adjacent solar cells are interconnected along the extension direction of the connection line by using the intra-string interconnection member, none of the corresponding second interconnection structures intersecting with the at least one intra-string interconnection member generates sintering stress on the target line segment, to reduce sintering stress formed along the extension direction of the target line segment, prevent an increase in the splitting risk of the solar cell caused by the large distribution density of the second interconnection structures on the target side, and ensure that the solar cell has a high yield rate.

For example, if the solar cell is the solar cell with no busbar, along the second direction, a size of the plurality of second interconnection structures is L1, a size of the plurality of first interconnection structures is L2, and 9 L1 > L2 > 3 L1. In this case, a small interconnection area between the solar cell and the intra-string interconnection member due to a small size of the plurality of second interconnection structures may be avoided, so that the solar cell and the intra-string interconnection member have high interconnection strength. In addition, a large paste consumption, metal compounding, and a large light-shielding area for manufacturing the first interconnection structure and the second interconnection structure that are caused by a large size of the plurality of second interconnection structures can also be avoided, to help reduce manufacturing costs of the solar cell, and improve conversion efficiency of the solar cell.

It should be noted that, when the solar cell provided in this embodiment of the present application is the solar cell with no busbar, a thickness and a cross-sectional area of the second interconnection structure may be determined based on an actual application scenario, and are not specifically limited herein. In addition, when the solar cell is the solar cell with no busbar, the solar cell may alternatively include only the first interconnection structure rather than the second interconnection structure.

For example, as shown in FIG. 4, the solar cell may further include busbars 16 arranged on the target side. Different busbars 16 located on the same target side extend along the second direction and are distributed at intervals along the first direction. The plurality of busbars 16 are electrically connected to the plurality of fingers 12 having a same polarity as the plurality of busbars, respectively, and are in electrical contact with at least one of the plurality of first interconnection structures 13. The different busbars 16 are in one-to-one correspondence with the different connection lines. In this case, the solar cell provided in this embodiment of the present application is the "solar cell with the busbar". Based on this, in an actual application process, a wire width of the finger 12 is usually small, to reduce a light-shielding area of the finger. However, the finger 12 is consequently prone to be cracked. However, existence of the busbar 16 can enable carriers collected by the finger 12 on two side of a cracking part to be respectively transmitted to busbars 16 connected to the finger 12, and exported, to improve a current collection capability and reducing a power loss.

In the foregoing case, if the solar cell is of the two-surface contact substrate structure, the busbars located on the same target side are electrically connected to all the fingers. If the solar cell is the back contact substrate structure, the fingers include a plurality of first fingers and a plurality of second fingers having opposite polarities to the plurality of first fingers, and the plurality of first fingers and the plurality of second fingers are alternately distributed at intervals along the second direction; the busbars include a plurality of first busbars and a plurality of second busbars having opposite polarities to the plurality of first busbars, and the plurality of first busbars and the plurality of second busbars are alternately distributed at intervals along the first direction; and the plurality of busbars and the plurality of fingers that have opposite polarities are mutually isolated. Specifically, the busbar and the finger may both be continuous electrodes. In this case, the busbar may be electrically isolated, by using an isolating material such as an isolating adhesive, from the finger whose polarity is opposite to that of the busbar. Alternatively, the finger may be a discontinuous finger, and the busbar is a continuous busbar. The busbar may be electrically isolated, through discontinuity of the discontinuous finger, from the finger whose polarity is opposite to that of the discontinuous finger. Alternatively, the busbar may be a discontinuous busbar, and the finger is a continuous finger. The finger may be electrically isolated, through discontinuity of the discontinuous busbar, from the busbar whose polarity is opposite to that of the discontinuous busbar. The positive electrode, which may be the back contact substrate structure, includes the foregoing first finger and first busbar. In this case, the negative electrode, which may be the back contact substrate structure, includes the foregoing second finger and second busbar. Alternatively, the negative electrode, which may be the back contact substrate structure, may include the foregoing first finger and first busbar. In this case, the positive electrode, which may be the back contact substrate structure, includes the foregoing second finger and second busbar.

It should be noted that the polarity of the finger included in the positive electrode is respectively opposite to that of the finger included in the negative electrode and that of the first interconnection structure (or the second interconnection structure) electrically connected to the finger included in the negative electrode. In addition, when the solar cell is the "solar cell with the busbar", the busbar included in the positive electrode is respectively opposite to that of the finger included in the negative electrode, that of the busbar included in the negative electrode, and that of the first interconnection structure electrically connected to the busbar included in the negative electrode.

In addition, in this embodiment of the present application, a quantity and an appearance of the finger included in the solar cell, and a distance between adjacent fingers are not specifically limited. Specifically, distances between different pairs of fingers may be equal, or may be not equal. It may be understood that, when a size of the finger is a fixed value, a carrier collection range corresponding to the finger is fixed. In this case, as shown in FIG. 2 and FIG. 4, the distances between the different pairs of fingers 12 are equal, so that, along the second direction, the different fingers 12 are evenly distributed. This helps avoid a case in which, because a distance between two adjacent fingers 12 with a same polarity in at least a pair of fingers 12 is greater than a distance between two adjacent fingers 12 with a same polarity in the remaining pair of fingers 12, it is difficult for at least one of the pair of the fingers 12 to collect a carrier within a large distance range and export the carrier in time, so that one side of the target side has a low carrier recombination rate. In addition, this helps avoid a case in which, because a distance between two adjacent fingers 12 with a same polarity in at least a pair of fingers 12 is less than a distance between two adjacent fingers 12 with a same polarity in the remaining pair of fingers 12, a distribution density of fingers 12 in a part of regions on one side of the target side is large, resulting in a large light-shielding area of the fingers 12 and a large metal composite loss between the finger 12 and the solar cell body 11, so that photoelectric conversion efficiency of the solar cell is improved.

In addition, when the solar cell provided in this embodiment of the present application includes the busbar, in this embodiment of the present application, a quantity and appearances of the busbars and a distance between adjacent busbars may be determined based on requirements on a quantity and appearances of the connection lines and a distance between adjacent connection lines in an actual application scenario. This is not specifically limited herein.

Directions specifically indicated by the first direction and the second direction may be based on an actual requirement, provided that the directions can be applied to the solar cell provided in this embodiment of the present application. For example, when a shape of the target side is a rectangle, the rectangle has a first side and a second side that are alternately distributed. The first direction may be parallel to the first side of the rectangle. In this case, the second direction may be parallel to the second side of the rectangle.

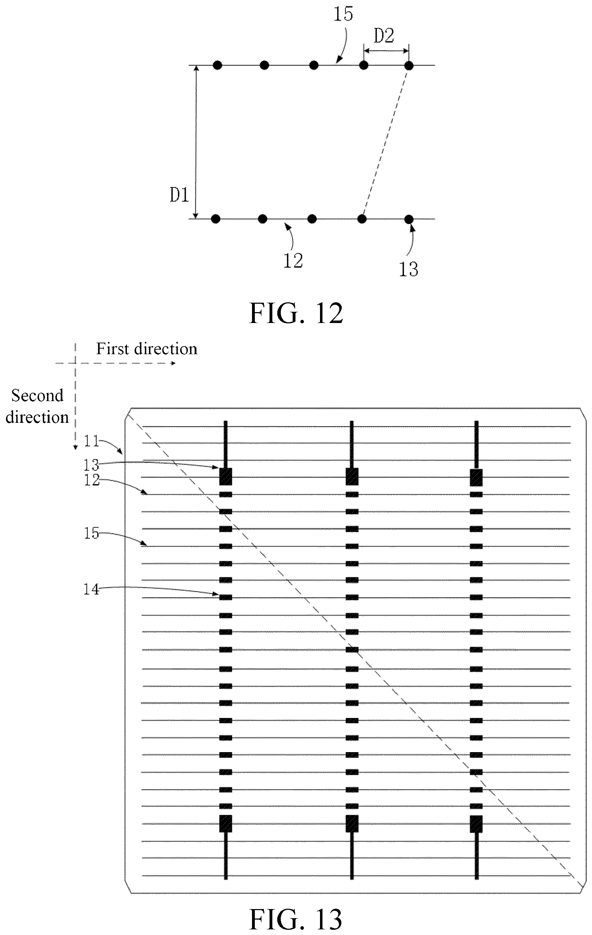

In an actual application process, as shown in FIG. 2 and FIG. 12, when the solar cell is the solar cell with no busbar, a finger 12 in contact with the first interconnection structure 13 is defined as a connection electrode 15. In addition, a distance between two adjacent connection electrodes 15 along the second direction is defined as D1. At least one of the connection electrodes 15 located in the edge region is in contact with the plurality of first interconnection structures 13, and different first interconnection structures 13 in electrical contact with the connection electrode 15 are distributed at intervals along the first direction. A distance between geometric centers of two adjacent first interconnection structures 13 in contact with the connection electrode 15 is defined as D2. In the foregoing case, it may be understood that, disposing of different connection electrodes 15 on the target side is different. Correspondingly, positions at which the first interconnection structures 13 that are in electrical contact with the different connection electrodes 15 are arranged on the target side are also different. A position at which the first interconnection structure 13 is arranged on the target side affects a value of N2. Exemplarily, a second interconnection structure 14 having a smaller size may further be distributed between two connection electrodes 15 shown in FIG. 12. The second interconnection structure 14 is electrically connected to a finger 12 between the two connection electrodes 15. In the foregoing case, in all the fingers 12 located on the same target side, specifically, a finger 12 in electrical contact with the first interconnection structure 13 and a finger 12 in electrical contact with the second interconnection structure 14 may be determined based on a size requirement on N2 in an actual application scenario, and are not specifically limited herein.

For example, when the solar cell is the solar cell with no busbar, first interconnection structures at two ends located in the edge region are in electrical contact with fingers located in the edge region, and second interconnection structures located in the middle region are in electrical contact with fingers located in the middle region. In this case, D1 is a distance between the two fingers that are in contact with the first interconnection structures at the ends and that are adjacent along the second direction, and D2 is a distance between geometric centers of the two first interconnection structures adjacent along the first direction.

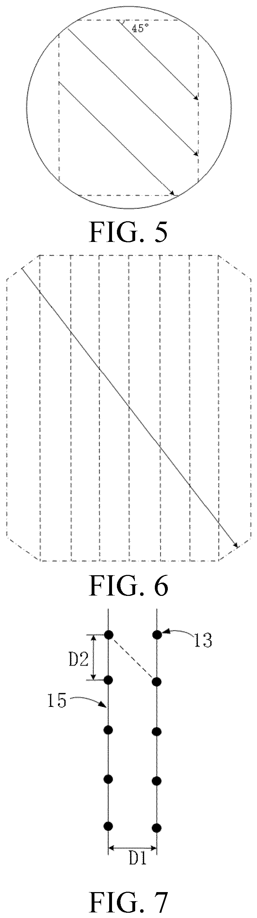

In addition, as shown in FIG. 4 and FIG. 7, when the solar cell is the solar cell with the busbar, the foregoing busbar 16 is defined as a connection electrode 15. In addition, a distance between two adjacent connection electrodes 15 along the first direction is defined as D1. At least one of the connection electrodes 15 is in contact with the plurality of first interconnection structures 13, and different first interconnection structures 13 in contact with a same connection electrode 15 are distributed at intervals along the second direction. A distance between geometric centers of two adjacent first interconnection structures 13 in contact with the same connection electrode 15 is defined as D2.

For example, when the solar cell is the solar cell with the busbar, the first interconnection structures located at the two ends of the edge region have larger sizes, and the first interconnection structures having the larger sizes are in electrical contact with the fingers located in the edge region. The first interconnection structures in the middle region have smaller sizes, the first interconnection structures having the smaller sizes are in electrical contact with the fingers located in the middle region. In this case, D1 is the distance between the two busbars adjacent along the first direction. D2 is the distance between the geometric centers of the two first interconnection structures that are in contact with the same busbar and that are adjacent along the first direction.

In the foregoing case, in the solar cell, first interconnection structures that are in contact with different connection electrode and that are on a same layer are aligned along the first direction, to reduce difficulty in connection of an automatic interconnection device, such as a series welding machine, interconnecting the adjacent solar cells. Based on this, as shown in FIG. 7 and FIG. 12, if D2 corresponding to each pair of first interconnection structures 13 is equal to D1, an inclination angle of a connection line between a first interconnection structure 13 arranged at layer of each connection electrode 15 and a first interconnection structure 13 arranged at an adjacent layer of an adjacent connection electrode 15 is equal to 45 degrees, so that N3 corresponding to each vector line segment whose inclination angle is 45 degrees is equal to N4. When D2 corresponding to the at least one pair of the first interconnection structures is not equal to D1, an inclination angle of a connection line between a first interconnection structure at a layer arranged on a connection electrode and a first interconnection structure at an adjacent layer arranged on an adjacent connection electrode is not equal to 45 degrees, so that an inclination angle of an interconnection stress zone corresponding to the pair of first interconnection structures is not equal to 45 degrees, to help reduce the length of the interconnection stress zone formed along the extension direction of the vector line segment whose inclination angle is 45 degrees, and also help reduce the length of the interconnection stress zone formed along the direction of the cleavage surface. Therefore, the risk that splitting occurs after the solar cell suffers the external force due to the long interconnection stress zone is reduced, and the structural reliability of the photovoltaic module formed based on the solar cell is improved.

Specifically, it may be understood that, when a length of the connection electrode is fixed, a larger ratio of D2 corresponding to the at least one pair of the first interconnection structures to D1 indicates a larger distance between the two adjacent first interconnection structures intersecting with the same connection electrode. On the contrary, a smaller ratio of D2 corresponding to the at least one pair of the first interconnection structures to D1 indicates a smaller distance between the two adjacent first interconnection structures intersecting with the same connection electrode. However, when the ratio is closer to 1, an inclination angle of a connection line between the pair of first interconnection structures is closer to 45 degrees, that is, closer to the extension direction of the cleavage surface. In the foregoing case, when D2 corresponding to the at least one pair of the first interconnection structures is not equal to D1, the specific ratio of D2 to D1 may be determined at least based on an inclination angle of an interconnection stress zone formed after the interconnection and a transmission loss of a carrier at the busbar in an actual application scenario. This is not specifically limited herein.

For example, when the solar cell is the solar cell with the busbar, a ratio of D2 corresponding to the at least one pair of the first interconnection structures to D1 may be greater than or equal to 1 and less than or equal to 1.7. For example, the ratio of D2 corresponding to the at least one pair of the first interconnection structures to D1 may be 1, 1.06, 1.1, 1.12, 1.14, 1.16, 1.2, 1.3, 1.4, 1.5, 1.6, or 1.7. In this case, when the ratio of D2 corresponding to the at least one pair of the first interconnection structures to D1 is within the foregoing range, it is beneficial to avoid a case in which an extension direction of an interconnection stress zone corresponding to the at least one pair of the first interconnection structures approaches the extension direction of the cleavage surface because the ratio is small, thereby ensuring that the length of the interconnection stress zone formed along the direction of the cleavage surface can be reduced. In addition, it is also beneficial to avoid a case in which, because the ratio is large, a distance between the two adjacent first interconnection structures intersecting with the same connection electrode is also large, resulting in a large transmission loss of a carrier at the connection electrode. This helps improve the working efficiency of the solar cell.

For example, when the solar cell is the solar cell with no busbar, a ratio of D1 corresponding to the at least one pair of the first interconnection structures to D2 may be greater than or equal to 6 and less than or equal to 12. For example, the ratio of D1 corresponding to the at least one pair of the first interconnection structures to D2 may be 6, 7, 8, 9, 10, 11, 12, or the like.

In addition, in an actual application process, in the plurality of first interconnection structures in contact with the same connection line, distances between two adjacent first interconnection structures may be equal or not equal. However, along the second direction, in the plurality of first interconnection structures in contact with the same connection line, a distance between geometric centers of the two adjacent first interconnection structures may affect a quantity of pairs of fingers arranged between the geometric centers of the two adjacent first interconnection structures. Each pair of fingers includes two fingers that have a same polarity as that of a corresponding first interconnection structure and that are adjacent along the second direction. Specifically, when distances between different pairs of fingers are equal, if the distance between the geometric centers of the two adjacent first interconnection structures is equal, the quantity of the pairs of fingers between the geometric centers of the two adjacent first interconnection structures is also equal. On the contrary, if the distance between the geometric centers of the two adjacent first interconnection structures is not equal, the quantity of the pairs of fingers between the geometric centers of the two adjacent first interconnection structures is also not equal. In the foregoing case, the distance between the geometric centers of the two adjacent first interconnection structures may be controlled by adjusting the quantity of the fingers located between the geometric centers of the two adjacent first interconnection structures, thereby regulating an extension direction of an interconnection stress zone formed by the two adjacent first interconnection structures after the interconnection.

According to a second aspect, an embodiment of the present application provides another solar cell. Specifically, the solar cell provided in this embodiment of the present application may be any solar cell that can convert light energy of the sun into electrical energy.

In terms of disposing positions of a positive electrode and a negative electrode, the solar cell provided in this embodiment of the present application may be a two-surface contact substrate structure, that is, one of the positive electrode and the negative electrode of the solar cell is arranged on a front surface of the solar cell, and the other is arranged on a back surface. Alternatively, the solar cell provided in this embodiment of the present application may be a back contact substrate structure, that is, both the positive electrode and the negative electrode of the solar cell are arranged on a back surface of the solar cell.

In terms of specific electrode structures of the positive electrode and the negative electrode, the solar cell provided in this embodiment of the present application may be a "solar cell with a busbar". In this case, the solar cell not only includes fingers, but also includes busbars, and different busbars are in one-to-one correspondence with different connection lines. Alternatively, the solar cell provided in this embodiment of the present application may alternatively be a "solar cell with no busbar". In this case, the solar cell with no busbar does not include the busbar in the solar cell with the busbar. Specifically, an electrode structure of the solar cell with no busbar may include only fingers, or may include fingers and a busbar segment that has a bus function (where the busbar segment may be electrically connected to a first interconnection structure located at an edge along a second direction, and extends toward an edge of the solar cell body along the second direction). A specific shape of the busbar segment is not limited, and may be, for example, a straight line, a curved line, or a harpoon structure.

Specifically, as shown in FIG. 1 and FIG. 3, the solar cell includes a solar cell body 11, a plurality of fingers 12, and a plurality of first interconnection structures 13. The solar cell body 11 has a first side and a second side opposite to the first side. At least one of the first side and the second side is a target side. The plurality of fingers 12 are arranged on the target side. Different fingers 12 arranged on a same target side at intervals along a second direction extend along a first direction. The first direction is perpendicular to the second direction. The plurality of first interconnection structures 13 are arranged in an array on the target side. Each of the plurality of first interconnection structures 13 is electrically connected to the at least one of the plurality of fingers 12. At least the part of the regions of the different first interconnection structures 13 arranged at intervals along the second direction are collinear with the same connection line of the plurality of connection lines, and the different connection lines of the plurality of connection lines are distributed at intervals along the first direction. A quantity of connection lines located on the same target side is N1, a quantity of first interconnection structures 13 intersecting with a target line segment located on the target side is N2, and N1 > N2. The target line segment is a diagonal line of the target side, and intersects with each of the connection lines. It should be noted that, the case in which N1 > N2 is applicable to all of the solar cell with no busbar, the solar cell with a busbar, the back contact substrate structure, and the two-surface contact substrate structure.

Specifically, the quantity N1 of the connection lines is a quantity of connection lines in each sliced cell unit (where generally, two sliced cell units have a same quantity of connection lines), and the quantity N1 of the connection lines is a positive integer greater than or equal to 1. The quantity N2 of first interconnection structures intersecting with the target line segment located on the target side is an integer greater than or equal to 0. The quantity N1 of the connection lines and the quantity N2 of the first interconnection structures intersecting with the target line segment located on the target side may be determined based on an actual application scenario, and are not specifically limited herein.

When the foregoing technical solution is used, the target line segment is the diagonal line of the target side, and intersects with each of the connection lines. In addition, when N2 < N1, it can be ensured that no first interconnection structure that can be in electrical contact with each of the at least one connection line intersecting with the target line segment on the target side in arranged on the target line segment. Therefore, after the adjacent solar cells are interconnected along the extension direction of the connection line by using the intra-string interconnection member, none of the corresponding first interconnection structures in electrical contact with each of the at least one intra-string interconnection members generates interconnection stress on the target line segment, thereby reducing interconnection stress caused along an extension direction of the target line segment. **In** this case, a direction of a diagonal line of a surface of a semiconductor wafer for manufacturing the solar cell is approximately parallel to a cleavage surface, and the cleavage surface is a surface on which a mineralogical crystal is strictly cracked along a crystal direction under an external force, and a smooth surface can be obtained through cracking. Therefore, corresponding to a silicon wafer, a nearly square silicon wafer is formed after linear cutting is performed on a monocrystalline silicon crystal rod, the cleavage surface intersects with a surface of the silicon wafer, and is not parallel to an edge of the silicon wafer. It may be understood that there are countless cleavage surfaces that are parallel to each other in the crystal rod, and countless target line segments that are parallel to each other are formed between the cleavage surfaces and the surface of the silicon wafer. A diagonal line of the silicon wafer corresponding to a longest target line segment, and faces a largest stress challenge. Therefore, when the target line segment is the diagonal line of the target side, the extension direction of the target line segment is approximately parallel to a direction of the cleavage surface of the solar cell body. **In** this case, reducing the interconnection stress caused along the extension direction of the target line segment is equivalent to reducing interconnection stress caused along the direction of the cleavage surface, to reduce a risk that splitting occurs after the solar cell suffers the external force due to the large interconnection stress, and improve structural reliability of a photovoltaic module formed based on the solar cell.

It should be noted that, it can be learned from the foregoing descriptions that the solar cell provided in the first aspect of the embodiments of the present application is a half of the solar cell. The solar cell provided in the second aspect of the embodiments of the present application is an entire solar cell. **In** this case, the solar cell provided in the first aspect of the embodiments of the present application may be considered as being obtained after the solar cell provided in the second aspect of the embodiments of the present application is half-sliced. Based on this, for a structure and a material of the solar cell body and distribution situations of the fingers and the first interconnection structures in the solar cell provided in the second aspect of the embodiments of the present application, refer to the foregoing descriptions, and details are not described herein again.

The following merely describes a difference between the solar cell provided in the second aspect of the embodiments of the present application and the solar cell provided in the first aspect of the embodiments of the present application.

Specifically, in the solar cell provided in the second aspect of the embodiments of the present application, a specific distribution position of the target line segment on the target side may be determined based on a distribution situation of line segments that intersect with each other and that are on the cleavage surface of the solar cell body and the target side, and based on a shape of the target side. This is not specifically limited herein. When a vertex angle of the target side is a sharp corner, the target line segment may be a connection line segment between diagonal endpoints of the target side. When the vertex angle of the target side is a chamfer in a manner such as rounded transition, the target line segment may be a connection line segment between endpoints of a diagonal extended line of the target side.

In addition, in an actual application process, as shown in FIG. 1 and FIG. 3, a quantity of connection lines intersecting with the target line segment is defined as N3. Based on this, N3 > N2. In this case, the target line segment intersects with only an extended line of at least one connection line, so that interconnection stress is not generated at a junction, thereby ensuring that the interconnection stress caused along the extension direction of the target line segment can be reduced, that is, facilitating reducing a length of an interconnection stress zone formed along the direction of the cleavage surface, further reducing a risk that splitting occurs after the solar cell suffers the external force due to the long interconnection stress zone, and improving structural reliability of a photovoltaic module formed based on the solar cell. In addition, the quantity N1 of the connection lines on the target side is greater than or equal to the quantity N3 of the connection lines intersecting with the target line segment. N1 is greater than N3 when a part of the first interconnection structures included in the solar cell are arranged on an edge of the target side along the first direction and connection lines of the first interconnection structures do not intersect with the target line segment. Alternatively, when four vertex angles of the target side are vertex angles having large chamfers, a part of the connection lines pass through the chamfers. In this case, N1 may be greater than N3. N1 is equal to N3 when all the first interconnection structures included in the solar cell are arranged in the middle of the target side along the first direction. Alternatively, when four vertex angles of the target side do not have a chamfer nor a small chamfer, all the connection lines do not pass through the chamfer. In this case, N1 may be equal to N3.

In addition, distribution of the fingers between the different first interconnection structures and distribution of the fingers between the first interconnection structure located at the edge along the second direction and a boundary of the solar cell body may be determined based on values of N1 and N2 in an actual application scenario, and are not specifically limited herein.

For example, as shown in FIG. 1 and FIG. 3, the solar cell may include M sliced cell units distributed at intervals along the second direction, and M is a positive integer greater than or equal to 1. Geometric centers of two first interconnection structures 13 located at an edge along the second direction in a same sliced cell unit are symmetrically arranged relative to a median line of the same sliced cell unit along the second direction. In this case, the geometric centers of the two first interconnection structures 13 located at the edge along the second direction in the same sliced cell unit are symmetrically arranged relative to the median line of the sliced cell unit along the second direction, to help enable an automatic interconnection device, such as a series welding machine, to interconnect different sliced cell units at a same starting position, thereby preventing dislocation that is between an intra-string interconnection member, such as a welding strip, and a first interconnection structure 13 arranged on the solar cell body 11 and that is caused by different starting positions corresponding to the different sliced cell units, where the dislocation further causes a case in which a carrier on a connection line corresponding to the first interconnection structure 13 not electrically connected to the intra-string interconnection member cannot be exported via the intra-string interconnection member, and a power loss occurs, or causes a case in which the corresponding first interconnection structure 13 becomes a load, resulting in reduction of working efficiency of the solar cell. Therefore, it is ensured that a photovoltaic module formed based on the solar cell provided in this embodiment of the present application has good working performance. Certainly, for the same sliced cell unit, the geometric centers of the two first interconnection structures 13 located on the edges along the second direction and a quantity of pairs of fingers 12 between edges of the sliced cell units may alternatively be not symmetrically arranged, to reduce a manufacturing requirement. It should be noted that, the case in which the geometric centers of the two first interconnection structures 13 located at the edge along the second direction in the same sliced cell unit are symmetrically arranged relative to the median line of the sliced cell unit along the second direction is applicable to all of the solar cell with no busbar, the solar cell with a busbar, the back contact substrate structure, and the two-surface contact substrate structure.

For example, when there is an odd number of first interconnection structures collinear with the same connection line of the plurality of connection lines, along the second direction, in the same sliced cell unit, except a first interconnection structure located in the middle and other two first interconnection structures adjacent to the first interconnection structure located in the middle, the remaining first interconnection structures are edge first interconnection structures. A quantity of pairs of the fingers located between geometric centers of two adjacent edge first interconnection structures are symmetrically arranged relative to a central axis of the first interconnection structure located in the middle. Alternatively, when there is an even number of first interconnection structures collinear with the same connection line of the plurality of connection lines, along the second direction, in the same sliced cell unit, except a first interconnection structure located in the middle, the remaining first interconnection structures are edge first interconnection structures. A quantity of pairs of the fingers 12 located between geometric centers of two adjacent edge first interconnection structures are symmetrically arranged relative to a central axis of a pair first interconnection structure located in the middle.

When the foregoing technical solution is used, for the same sliced cell unit, when the quantity of the first interconnection structures in contact with the same connection line is an odd number, it is defined that, along the second direction, in the same sliced cell unit, except a first interconnection structure located in the middle and other two first interconnection structures adjacent to the first interconnection structure located in the middle, the remaining first interconnection structures are the edge first interconnection structures. **In** the foregoing case, when the quantity of pairs of the fingers located between geometric centers of two adjacent edge first interconnection structures are symmetrically arranged relative to a central axis of the first interconnection structure located in the middle, it is beneficial to distribute different fingers between the geometric centers of the two adjacent first interconnection structures along the second direction as evenly as possible, thereby facilitating lapping of the corresponding fingers and the first interconnection structures, maximizing current collection, facilitating debugging of an interconnection device interconnecting the adjacent solar cells, and preventing interconnection dislocation. **In** addition, when the quantity of pairs of the first interconnection structures collinear with the same connection line of the plurality of connection lines is an even number, along the second direction, in the same sliced cell unit, except the first interconnection structure located in the middle, the remaining first interconnection structures are the edge first interconnection structures. **In** addition, for beneficial effects that the quantity of pairs of the fingers located between geometric centers of two adjacent edge first interconnection structures are symmetrically arranged relative to a central axis of a pair first interconnection structure located in the middle, refer to the foregoing descriptions, and details are not described herein again.

An example is used below in which a quantity of first interconnection structures in contact with a same connection line is 7, and a same sliced cell unit is provided with 92 fingers having a same polarity (which are 91 pairs of fingers), to describe, when the quantity of the first interconnection structures in contact with the same connection line is an odd number, a quantity of fingers located between geometric centers of two adjacent first interconnection structures in the same sliced cell unit along the second direction. Different first interconnection structures intersecting with the same connection line are sorted from top to bottom. In this case, a first interconnection structure located in the middle is the 4th first interconnection structure. In the same sliced cell unit, the 1st and the 2nd first interconnection structures and the 6th and the 7th first interconnection structures are edge first interconnection structures. In the foregoing case, a quantity of pairs of fingers between geometric centers of the 1st and the 2nd first interconnection structures is 12. A quantity of pairs of fingers between geometric centers of the 2nd and the 3rd first interconnection structures is 11. A quantity of pairs of fingers between geometric centers of the 5th and the 6th first interconnection structures is 11. A quantity of pairs of fingers between geometric centers of the 6th and the 7th first interconnection structures is 12. Along the second direction, there are 11 pairs of fingers between the geometric centers of the first interconnection structures (that is, the 1st first interconnection structure and the 7th first interconnection structure) located at the edge and the edge of the solar cell body.

The following uses the structures shown in FIG. 1 and FIG. 3 as an example, to describe, when there is an even number of first interconnection structures in contact with the same connection line, a quantity of pairs of fingers located between geometric centers of two adjacent first interconnection structures in the same sliced cell unit along the second direction. As shown in FIG. 1 and FIG. 3, the quantity of first interconnection structures 13 in contact with the same connection line is 6, and 27 finger 12 (which are 26 pairs of fingers 12) having a same polarity are arranged in the same sliced cell unit. Different first interconnection structures 13 intersecting with the same connection line are sorted from top to bottom. In this case, a middle pair of first interconnection structures 13 is the 3rd first interconnection structure 13 and the 4th first interconnection structure 13. The 1st first interconnection structure 13, the 2nd first interconnection struc-

ture 13, the 5th first interconnection structure 13, and the 6th first interconnection structure 13 are all edge first interconnection structures. Specifically, a quantity of pairs of fingers 12 between geometric centers of the 1st first interconnection structure 13 and the 2nd first interconnection structure 13 is 4. A quantity of pairs of fingers 12 between geometric centers of the 5th first interconnection structure 13 and the 6th first interconnection structure 13 is also 4. Along the second direction, quantities of pairs of fingers 12 between the geometric centers of the first interconnection structures 13 (that is, the 1st first interconnection structure 13 and the 6th first interconnection structure 13) located at the edge and the edge of the solar cell body 11 are all 3.

In an actual application process, it is defined that the quantity of the first interconnection structures in contact with the same connection line is a, a length of a part corresponding to each sliced cell unit in the solar cell body along the second direction is b, and a distance between adjacent fingers with a same polarity is c. A quantity d1 of pairs of the fingers that can be arranged in the sliced cell unit may be obtained by dividing b by c. An average quantity d2 of pairs of fingers that can be arranged between geometric centers of two adjacent first interconnection structures corresponding to the same connection line or in a distance between a geometric center of the plurality of first interconnection structures located at the edge along the second direction and the edge of the solar cell body may be obtained by dividing d1 by (a+1). If d2 is an integer, distances between geometric centers of different pairs of first interconnection structures (where each pair of first interconnection structures is two adjacent first interconnection structures intersecting with the same connection line) in contact with the same connection line are equal. If d2 has a remainder, a distance between geometric centers of at least one pair of first interconnection structures in contact with the same connection line is not equal to a distance between geometric centers of a remaining pair of first interconnection structures. Specifically, when d2 has a remainder, an actual quantity of pairs of fingers located between the geometric centers of each pair of the first interconnection structures may be set according to the foregoing symmetry rule, and details are not described herein again.

For example, when the solar cell is the back contact substrate structure and the solar cell includes at least two sliced cell units distributed at intervals along the second direction, a cutting channel is provided between two adjacent sliced cell units. In addition, fingers having opposite polarities in two adjacent sliced cell units are symmetrically arranged relative to the cutting channel, and/or first interconnection structures having opposite polarities in the two adjacent sliced cell units are symmetrically arranged relative to the cutting channel, and/or busbars having opposite polarities in the two adjacent sliced cell units are symmetrically arranged relative to the cutting channel. In this case, in the two adjacent sliced cell units, at least one pair of the fingers, first interconnection structures, and busbars having opposite polarities are symmetrically arranged relative to the cutting channel, to facilitate interconnection between the pair, avoid dislocation, improve an interconnection yield rate, and reduce interconnection difficulty. It should be noted that, the case in which, in the two adjacent sliced cell units, the fingers (and/or the first interconnection structures, and/or the busbars) having opposite polarities are symmetrically arranged relative to the cutting channel is applicable to both the back contact substrate structures of the solar cell with no busbar and the solar cell with the busbar.

For example, when the target line segment is the diagonal line of the target side, in the plurality of first interconnection structures intersecting with the target line segment, at least two first interconnection structures are symmetrically distributed by using a geometric center of the target side as a center, and the first interconnection structures that are symmetrically distributed may have a same polarity. In this case, it is beneficial to evenly distribute the first interconnection structures intersecting with the target line segment, and it is beneficial to evenly distribute the interconnection stress generated by the first interconnection structures on the target line segment after the interconnection by using the geometric center of the target side as a center, to prevent a high risk that the solar cell body cracks in a part of regions of the target line segment due to uneven distribution of the first interconnection structures on the target line segment and concentration of the interconnection stress on the region, thereby further improving the structural reliability of the photovoltaic module formed based on the solar cell.

Alternatively, as shown in FIG. 8 and FIG. 10, if the target line segment is the diagonal line of the target side, at least two first interconnection structures 13 of all the first interconnection structures 13 intersecting with the target line segment are symmetrically distributed by using a geometric center of the target side as a center, and the first interconnection structures 13 that are symmetrically distributed may alternatively have opposite polarities.

For example, when the solar cell includes two sliced cell units distributed at intervals along the second direction, N2 corresponding to the two sliced cell units are equal. As shown in FIG. 10, two busbars 16 located on an outer side along the first direction in a same sliced cell unit have opposite polarities. Two busbars 16 that are arranged opposite to each other on an outer side along the first direction and belong to different sliced cell units have opposite polarities. In this case, symmetry between different first interconnection structures 13 that are located on the same target side and have opposite polarities is improved, and difficulty in interconnecting the adjacent solar cells by using an automatic interconnection device such as a series welding machine is reduced.

It should be noted that, the foregoing case in which, when the solar cell includes two sliced cell units distributed at intervals along the second direction, N2 corresponding to the two sliced cell units are equal is applicable to both the back contact substrate structures of the solar cell with no busbar and the solar cell with the busbar.

For example, when the solar cell includes two sliced cell units distributed at intervals along the second direction, N2 corresponding to the two sliced cell units are not equal. Two busbars located on an outer side along the first direction in a same sliced cell unit have a same polarity. Two busbars that are arranged opposite to each other on an outer side along the first direction and belong to different sliced cell units have opposite polarities. In this case, another possible implementation is provided for the solar cell provided in this embodiment of the present application, to improve applicability of the solar cell provided in this embodiment of the present application in different application scenarios.

For example, when two busbars located on an outer side along the first direction have opposite polarities, in the plurality of first interconnection structures intersecting with the target line segment, at least two first interconnection structures may have a same distance to a median line of the target side along the second direction and have a same polarity. In this case, distribution uniformity of different first interconnection structures that are located on the same target side and have a same polarity is improved, and difficulty in interconnecting the adjacent solar cells by using an automatic interconnection device such as a series welding machine is reduced.

Alternatively, as shown in FIG. 11, when two busbars 16 located on an outer side along the first direction have opposite polarities, in the plurality of first interconnection structures 13 intersecting with the target line segment, at least two first interconnection structures 13 may have a same distance to a median line of the target side along the second direction and have a same polarity.

For example, when the solar cell is the solar cell with no busbar, the solar cell may alternatively include a second interconnection structure arranged on the target side. Each of the plurality of second interconnection structures is electrically connected to at least one of the plurality of fingers, and a size of the plurality of second interconnection structures is less than a size of the plurality of first interconnection structures. At least a part of regions of each of the plurality of second interconnection structures are located on a same straight line, and are collinear with the connection line. One part of the plurality of fingers located on the same target side are in contact with the plurality of first interconnection structures. For example, the first interconnection structure is located in two edge regions of the solar cell with no busbar along the second direction. The other part of the plurality of fingers are in contact with the plurality of second interconnection structures. For example, the second interconnection structure is located in a middle region of the solar cell with no busbar along the second direction. A quantity of the plurality of second interconnection structures intersecting with the target line segment is N8.

$$N8 > \frac{1}{2} N1$$

, and/or N8 < 1.5 N1. For example, N8 may be equal to 0.6 N1, 0.7 N1, 0.8 N1, 0.9 N1, N1, 1.1 N1, 1.2 N1, 1.3 N1, or 1.4 N1. For an application principle of beneficial effects in this case, refer to the foregoing

application principle of $$N7 > \frac{1}{3} N1$$ and N7 < N1, and details are not described herein again.

According to a third aspect, an embodiment of the present application provides a photovoltaic module. The photovoltaic module includes a plurality of solar cells and a plurality of intra-string interconnection members each connecting two adjacent solar cells in series. The solar cell is the solar cell provided in the first aspect and the implementations of the first aspect, or the solar cell provided in the second aspect and the implementations of the second aspect. Each of the intra-string interconnection members is in electrical contact with a corresponding first interconnection structure.

It may be understood that, when the solar cell is of the two-surface contact substrate structure, is the solar cell with no busbar, or is the solar cell with the busbar, the intra-string interconnection member may be located on different surfaces of two adjacent solar cells. Alternatively, the intra-string interconnection member is located on a same surface of two adjacent solar cells when the solar cells is the back contact substrate structure.

For beneficial effects of the third aspect and various implementations of the third aspect in this embodiment of the present application, refer to analysis of the beneficial effects of the first aspect and the implementations of the first aspect, or refer to analysis of the beneficial effects of the second aspect and the implementations of the second aspect, and details are not described herein again.

According to a fourth aspect, an embodiment of the present application provides another photovoltaic module. The photovoltaic module includes a plurality of solar cells and a plurality of intra-string interconnection members each connecting two adjacent solar cells in series. As shown in FIG. 2 and FIG. 4, each of the plurality of solar cells includes a solar cell body 11, a plurality of fingers 12, and a plurality of first interconnection structures 13. The solar cell body 11 has a first side and a second side opposite to the first side. At least one of the first side and the second side is a target side. The plurality of fingers 12 are arranged on the target side. Different fingers 12 arranged on a same target side at intervals along a second direction extend along a first direction. The first direction is perpendicular to the second direction. Each of the plurality of first interconnection structures 13 is electrically connected to the at least one of the plurality of fingers 12. Each of the intra-string interconnection members is in electrical contact with a corresponding first interconnection structure 13. A quantity of first interconnection structures 13 intersecting with a target line segment located on the target side is N2, and the target line segment is a connection line segment between a midpoint of an edge that has a larger length in two edges of the target side extending along the first direction and being arranged opposite to each other and a vertex-angle endpoint corresponding to an edge that has a smaller length in the two edges. A quantity of intra-string interconnection members located on the same target side is N5. A quantity of first interconnection structures 13 intersecting with the same vector line segment whose inclination angle is 45 degrees is N4. A quantity of intra-string interconnection members intersecting with the same vector line segment whose inclination angle is 45 degrees is N6.

$$N2 < \frac{1}{2} N5$$

, or N6 > N4.

In an embodiment, N2 corresponding to at least two solar cells in a same photovoltaic module are equal.

For beneficial effects of the fourth aspect and various implementations of the fourth aspect of the embodiments of the present application, refer to analysis of the beneficial effects of the first aspect and the implementations of the first aspect, and details are not described herein again.

In the foregoing descriptions, technical details such as pattering and etching of the layers are not described in detail. However, a person skilled in the art should understand that the layer, the region, and the like of a required shape may be formed by using various technical means. In addition, to form a same structure, a person skilled in the art may design a method that is not completely the same as the method described above. In addition, although the foregoing describes the embodiments separately, it does not mean that measures in the embodiments cannot be favorably combined.

The embodiments of the present application are described above. However, these embodiments are merely for the purpose of description, but are not intended to limit the scope of the present application. Therefore, the scope of the present application is subject to the claims and equivalents thereof. A person skilled in the art may make various replacements and modifications without departing from the scope of the present application, and these replacements and modifications shall fall within the scope of the present application.

**Claims**

1. A solar cell, comprising:

a solar cell body, wherein the solar cell body has a first side and a second side opposite to the first side, at least one of the first side and the second side being a target side;
a plurality of fingers, arranged on the target side, wherein different fingers arranged on a same target side at intervals along a second direction and extend along a first direction, the first direction being perpendicular to the second direction; and
a plurality of first interconnection structures arranged in an array on the target side, wherein each of the plurality of first interconnection structures is electrically connected to at least one of the plurality of fingers, at least a part of regions of different first interconnection structures arranged at intervals along the second direction are collinear with a same connection line of a plurality of connection lines, different connection lines of the plurality of connection lines are distributed at intervals along the first direction, wherein
a quantity of connection lines located on the same target side is N1, a quantity of first interconnection structures intersecting with a target line segment located on the target side is N2,

$$N2 < \frac{1}{2} N1$$

, the target line segment being a connection line segment between a midpoint of an edge that has a larger length in two edges of the target side extending along the first direction and being arranged opposite to each other and a vertex-angle endpoint corresponding to an edge that has a smaller length in the two edges; or a quantity of connection lines intersecting with a vector line segment whose inclination angle is 45 degrees is N3, a quantity of first interconnection structures intersecting with the same vector line segment whose inclination angle is 45 degrees is N4, N3 > N4.

2. The solar cell according to claim 1, wherein a thickness of the solar cell body is H1, a thickness of the first interconnection structure being H2, a ratio of H2 to H1 being greater than or equal to 0.005 and less than or equal to 0.1; and/or
a cross-sectional area of the solar cell body is S1, a cross-sectional area of the first interconnection structures being S2, a ratio of S2 to S1 being greater than or equal to 0.0003 and less than or equal to 0.02.

3. The solar cell according to claim 1, wherein N2 is equal to 0.

4. The solar cell according to claim 1, wherein a distance between a geometric center of the plurality of first interconnection structures intersecting with the target line segment or the vector line segment whose inclination angle is 45 degrees and a median line of the solar cell along the second direction is D3; and a distance between the geometric center of the plurality of first interconnection structures intersecting with the target line segment or the vector line segment whose inclination angle is 45 degrees and an edge of the solar cell along the second direction is D4, D3 corresponding to at least one of the first interconnection structures > D4.

5. The solar cell according to claim 1, wherein the solar cell is a solar cell with no busbar; the target side comprising a middle region and an edge region along the second direction, at least a part of the plurality of fingers located in the edge region being in electrical contact with the first interconnection structure.

6. The solar cell according to claim 5, wherein the solar cell is a back contact substrate structure, the plurality of fingers comprising a plurality of first fingers and a plurality of second fingers having opposite polarities to the plurality of first fingers, the plurality of first fingers and the plurality of second fingers being alternately distributed at intervals along the second direction, at least a part of the plurality of first fingers in the edge region are in electrical contact with respective first interconnection structures of the plurality of first interconnection structures, and at least a part of the plurality of second fingers in the edge region being in electrical contact with respective first interconnection structures of the plurality of first interconnection structures.

7. The solar cell according to claim 5, wherein the solar cell further comprises a plurality of second interconnection structures arranged on the target side, each of the plurality of second interconnection structures being electrically connected to at least one of the plurality of fingers, a size of the plurality of second interconnection structures being less than a size of the plurality of first interconnection structures, at least a part of regions of each of the plurality of second interconnection structures being located on a same straight line, and being collinear with the connection line;

one part of the plurality of fingers located on the same target side are in contact with the plurality of first interconnection structures, and the other part of the plurality of fingers are in contact with the plurality of second interconnection structures, the part of the plurality of fingers in contact with the plurality of first interconnection structures being connection electrodes; and
a distance between two adjacent connection electrodes along the second direction is D1, at least one of the connection electrodes located in the edge region being in contact with the plurality of first interconnection structures, different first interconnection structures in contact with a same connection electrode being distributed at intervals along the first direction, a distance between geometric centers of two adjacent first interconnection structures in contact with the same connection electrode being D2, D2 corresponding to at least one pair of the first interconnection structures being not equal to D1, each pair of the first interconnection structures being two adjacent first interconnection structures in contact with the same connection electrode.

8. The solar cell according to claim 7, wherein a quantity of the plurality of second interconnection structures intersecting with the target line segment or the vector line segment whose inclination angle is 45 degrees is N7,

$$N7 > \frac{1}{3} N1; \text{ and/or } N7 < N1.$$

9. The solar cell according to claim 7, wherein a ratio of D1 corresponding to the at least one pair of the first interconnection structures to D2 is greater than or equal to 6 and less than or equal to 12.

10. The solar cell according to claim 1, further comprising a plurality of busbars arranged on the target side, wherein different busbars located on the same target side extend along the second direction and are distributed at intervals along the first direction, the plurality of busbars being electrically connected to the plurality of fingers having a same polarity as the plurality of busbars, respectively, and are in electrical contact with at least one of the plurality of first interconnection structures, different busbars being in one-to-one correspondence with different connection lines.

11. The solar cell according to claim 10, wherein the plurality of busbars are connection electrodes, wherein

a distance between two adjacent connection electrodes along the first direction is D1; and
at least one of the connection electrodes is in contact with the plurality of first interconnection structures, different first interconnection structures in contact with a same connection electrode being distributed at intervals along the second direction; a distance between geometric centers of two adjacent first interconnection structures in contact with the same connection electrode being D2, D2 corresponding to at least one pair of the first interconnection structures being not equal to D1, each pair of the first interconnection structures being two adjacent first interconnection structures in contact with the same connection electrode.

12. The solar cell according to claim 11, wherein a ratio of D2 corresponding to the at least one pair of the first interconnection structures to D1 is greater than or equal to 1 and less than or equal to 1.7.

13. A solar cell, comprising:

a solar cell body, wherein the solar cell body has a first side and a second side opposite to the first side, at least one of the first side and the second side being a target side; a plurality of fingers, arranged on the target side, wherein different fingers arranged on a same target side at intervals along a second direction extend along a first direction, the first direction being perpendicular to the second direction; and a plurality of first interconnection structures arranged in an array on the target side, wherein each of the plurality of first interconnection structures is electrically connected to at least one of the plurality of fingers, at least a part of regions of different first interconnection structures arranged at intervals along the second direction are collinear with a same connection line of a plurality of connection lines, different connection lines of the plurality of connection lines are distributed at intervals along the first direction, wherein a quantity of connection lines located on the same target side is N1, a quantity of first interconnection structures intersecting with a target line segment located on the target side being N2, N1 > N2, the target line segment being a diagonal line of the target side, and intersects with each of the connection lines.

14. The solar cell according to claim 13, wherein the solar cell comprises at least two sliced cell units distributed at intervals along the second direction, a cutting channel is provided between two adjacent sliced cell units, wherein

the plurality of fingers that have opposite polarities in the two adjacent sliced cell units are symmetrically arranged relative to the cutting channel; and/or the plurality of first interconnection structures that have opposite polarities in the two adjacent sliced cell units are symmetrically arranged relative to the cutting channel; and/or the solar cell further comprises a plurality of busbars arranged on the target side; different busbars located on the same target side extending along the second direction and being distributed at intervals along the first direction, the plurality of busbars being electrically connected to the plurality of fingers having a same polarity as the plurality of busbars, respectively, and being in contact with at least one of the plurality of first interconnection structures, different busbars being in one-to-one correspondence with different connection lines, the plurality of busbars that have opposite polarities in the two adjacent sliced cell units being symmetrically arranged relative to the cutting channel.

15. The solar cell according to claim 13, wherein:

the solar cell comprises M sliced cell units distributed at intervals along the second direction, M being a positive integer greater than or equal to 1; and geometric centers of two first interconnection structures located at an edge along the second direction in a same sliced cell unit are symmetrically arranged relative to a median line of the same sliced cell unit along the second direction.

16. The solar cell according to claim 13, wherein the solar cell further comprises a plurality of busbars arranged on the target side, different busbars located on the same target side extending along the second direction and being distributed at intervals along the first direction, the plurality of busbars being electrically connected to the plurality of fingers having a same polarity as the plurality of busbars, respectively, and being in contact with at least one of the plurality of first interconnection structures, different busbars being in one-to-one correspondence with different connection lines; and the plurality of fingers comprise a plurality of first fingers and a plurality of second fingers having opposite polarities to the plurality of first fingers, the plurality of first fingers and the plurality of second fingers being alternately distributed at intervals along the second direction, the busbars comprise a plurality of first busbars and a plurality of second busbars having opposite polarities to the plurality of first busbars, the plurality of first busbars and the plurality of second busbars being alternately distributed at intervals along the first direction, the plurality of busbars and the plurality of fingers that have opposite polarities being mutually isolated.

17. The solar cell according to claim 16, wherein when two busbars located on an outer side along the first direction have opposite polarities, in the plurality of first interconnection structures intersecting with the target line segment, at least two first interconnection structures have a same distance to a median line of the target side along the second direction and have a same polarity.

18. The solar cell according to claim 16, wherein when the solar cell comprises two sliced cell units distributed at intervals along the second direction, N2 corresponding to the two sliced cell units are equal, two busbars located on an outer side along the first direction in a same sliced cell unit having opposite polarities, two busbars that are arranged opposite to each other on an outer side along the first direction and belong to different sliced cell units having opposite polarities; or
when the solar cell comprises two sliced cell units distributed at intervals along the second direction, N2 corresponding to the two sliced cell units are not equal, two busbars located on an outer side along the first direction in a same sliced cell unit having a same polarity, and two busbars that are arranged opposite to each other on an outer side along the first direction and belong to different sliced cell units having opposite polarities.

19. The solar cell according to claim 13, wherein the solar cell is a solar cell with no busbar, the solar cell further comprising a plurality of second interconnection structures arranged on the target side, each of the plurality of second interconnection structures being electrically connected to at least one of the plurality of fingers, a size of the plurality of second interconnection structures being less than a size of the plurality of first interconnection structures, at least a part of regions of each of the plurality of second interconnection structures being located on a same straight line, and being collinear with the connection line;

one part of the plurality of fingers located on the same target side are in contact with the plurality of first interconnection structures, and the other part of the plurality of fingers are in contact with the plurality of second interconnection structures; and
a quantity of the plurality of second interconnection structures intersecting with the target line segment is N8, $N8 > \frac{1}{2} N1$, and/or $N8 < 1.5 N1$.

20. A photovoltaic module, comprising the solar cell according to any one of claims 1 to 12, or the solar cell according to any one of claims 13 to 19.

21. A photovoltaic module, wherein the photovoltaic module comprises a plurality of solar cells and a plurality of intra-string interconnection members each connecting two adjacent solar cells in series, wherein:

each of the plurality of solar cells comprises a solar cell body, a plurality of fingers, and a plurality of first interconnection structures, the solar cell body having a first side and a second side opposite to the first side, at least one of the first side and the second side being a target side;
the plurality of fingers are arranged on the target side, different fingers arranged on a same target side at intervals along a second direction extending along a first direction, the first direction being perpendicular to the second direction;
each of the plurality of first interconnection structures is electrically connected to at least one of the plurality of fingers, and each of the intra-string interconnection members being in electrical contact with a corresponding first interconnection structure;
a quantity of first interconnection structures intersecting with a target line segment located on the target side is N2, the target line segment being a connection line segment between a midpoint of an edge that has a larger length in two edges of the target side extending along the first direction and being arranged opposite to each other and a vertex-angle endpoint corresponding to an edge that has a smaller length in the two edges, a quantity of intra-string interconnection members located on the same target side being N5, a quantity of first interconnection structures intersecting with at least one same vector line segment whose inclination angle is 45 degrees being N4, a quantity of intra-string interconnection members intersecting with the same vector line segment whose inclination angle is 45 degrees being N6,

$$N2 < \frac{1}{2} N5, \text{ or } N6 > N4.$$

22. The photovoltaic module according to claim 21, wherein N2 corresponding to at least two solar cells in a same photovoltaic module are equal.

First direction

Second
direction

11

12

15

14
13

**FIG. 1**

First direction

Second
direction

11

12

15

14
13

**FIG. 2**

FIG. 3

FIG. 4

FIG. 5

FIG. 6

FIG. 7

First direction

Second
direction

11

12

15

14

13

**FIG. 8**

First direction

Second
direction

11

12

12

14

13

**FIG. 9**

First direction

Second
direction

15  16
11
12
13

## FIG. 10

First direction

Second
direction

15  16
11
12
13

## FIG. 11

FIG. 12

FIG. 13

FIG. 14

## INTERNATIONAL SEARCH REPORT

| International application No. |
|---|
| **PCT/CN2024/130624** |

| A. | CLASSIFICATION OF SUBJECT MATTER |
|---|---|

H01L31/0224(2006.01)i;  H01L31/04(2014.01)i

According to International Patent Classification (IPC) or to both national classification and IPC

| B. | FIELDS SEARCHED |
|---|---|

Minimum documentation searched (classification system followed by classification symbols)

    IPC:H01L

Documentation searched other than minimum documentation to the extent that such documents are included in the fields searched

Electronic data base consulted during the international search (name of data base and, where practicable, search terms used)

    CNABS; CNTXT; CNKI; VEN; WOTXT; USTXT; EPTXT: 太阳, 光伏, 细栅, 副栅, 集电, 互连, 焊盘, 连接, 汇流, 间隔, 数量, 分布, 相交, 应力, 裂片, 破裂, solar, photovoltaic, collector, electrode, interconnect, pad, bar, number, stress, split

| C. | DOCUMENTS CONSIDERED TO BE RELEVANT |
|---|---|

| Category* | Citation of document, with indication, where appropriate, of the relevant passages | Relevant to claim No. |
|---|---|---|
| PX | CN 118116984 A (LONGI GREEN ENERGY TECHNOLOGY CO., LTD.) 31 May 2024 (2024-05-31)<br>    description, paragraphs [0004]-[0118], and figures 1-11 | 1-22 |
| A | CN 211828804 U (SUZHOU CSI SOLAR POWER TECHNOLOGY CO., LTD. et al.) 30 October 2020 (2020-10-30)<br>    description, paragraphs [0005]-[0048], and figures 1-8 | 1-22 |
| A | CN 218677159 U (LONGI SOLAR TECHNOLOGY (TAIZHOU) CO., LTD.) 21 March 2023 (2023-03-21)<br>    entire document | 1-22 |
| A | CN 219163409 U (LONGI SOLAR TECHNOLOGY (TAIZHOU) CO., LTD.) 09 June 2023 (2023-06-09)<br>    entire document | 1-22 |
| A | US 2024136455 A1 (ZHEJIANG JINKO SOLAR CO., LTD.) 25 April 2024 (2024-04-25)<br>    entire document | 1-22 |

☐ Further documents are listed in the continuation of Box C.  ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **05 December 2024** | **11 December 2024** |

| Name and mailing address of the ISA/CN | Authorized officer |
|---|---|
| **China National Intellectual Property Administration (ISA/CN)**<br>**China No. 6, Xitucheng Road, Jimenqiao, Haidian District, Beijing 100088** | |
| | Telephone No. |

Form PCT/ISA/210 (second sheet) (July 2022)

## INTERNATIONAL SEARCH REPORT
### Information on patent family members

International application No.

**PCT/CN2024/130624**

| Patent document cited in search report | | | Publication date (day/month/year) | Patent family member(s) | | | Publication date (day/month/year) |
|---|---|---|---|---|---|---|---|
| CN | 118116984 | A | 31 May 2024 | CN | 118116984 | B | 06 September 2024 |
| CN | 211828804 | U | 30 October 2020 | CN | 113690333 | A | 23 November 2021 |
| | | | | CN | 113690333 | B | 16 April 2024 |
| CN | 218677159 | U | 21 March 2023 | | None | | |
| CN | 219163409 | U | 09 June 2023 | WO | 2024099014 | A1 | 16 May 2024 |
| | | | | EP | 4443522 | A1 | 09 October 2024 |
| US | 2024136455 | A1 | 25 April 2024 | US | 2024234605 | A9 | 11 July 2024 |
| | | | | US | 12080819 | B2 | 03 September 2024 |
| | | | | JP | 2024062419 | A | 09 May 2024 |
| | | | | JP | 7376672 | B1 | 08 November 2023 |
| | | | | JP | 2024062319 | A | 09 May 2024 |
| | | | | AU | 2023286031 | A1 | 25 January 2024 |
| | | | | EP | 4362108 | A1 | 01 May 2024 |
| | | | | AU | 2022279534 | B1 | 07 December 2023 |

Form PCT/ISA/210 (patent family annex) (July 2022)

**EP 4 597 542 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202410517763